# EUROPÄISCHE PATENTSCHRIFT

(11) **EP 3 329 597 B1**
(45) Veröffentlichungstag und Bekanntmachung des Hinweises auf die Patenterteilung: **12.08.2020**
(21) Anmeldenummer: 16751529.5
(22) Anmeldetag: 29.07.2016
(51) Int. Cl.: H03K 17/96

(54) **BEDIENEINRICHTUNG FÜR EIN FAHRZEUG UND VERFAHREN ZUM BETRIEB EINER SOLCHEN BEDIENEINRICHTUNG**
CONTROL DEVICE FOR A VEHICLE AND METHOD FOR OPERATING SUCH A CONTROL DEVICE
DISPOSITIF DE COMMANDE D'UN VÉHICULE ET PROCÉDÉ DE FONCTIONNEMENT D'UN TEL DISPOSITIF DE COMMANDE

(30) Priorität: 30.07.2015 DE 102015112444
(43) Veröffentlichungstag der Anmeldung: 06.06.2018
(73) Patentinhaber: Valeo Schalter und Sensoren GmbH, 74321 Bietigheim-Bissingen (DE)
(72) Erfinder: STAUDE, Sascha, 74321 Bietigheim-Bissingen (DE)
(74) Vertreter: Pothmann, Karsten
(86) Internationale Anmeldenummer: PCT/EP2016/068171
(87) Internationale Veröffentlichungsnummer: WO 2017/017255

(56) Entgegenhaltungen:
- US-A- 3 879 618
- US-A1- 2006 158 041
- US-A1- 2008 246 723
- US-A1- 2010 181 180
- US-A1- 2012 074 961
- US-A1- 2012 227 259
- US-A1- 2013 088 372

## Beschreibung

Die Erfindung betrifft eine Bedieneinrichtung für ein Fahrzeug, insbesondere eine Bedieneinrichtung zur Steuerung sicherheitsrelevanter Funktionen, wobei die Bedieneinrichtung wenigstens eine Bedienoberfläche mit wenigstens einem Bedieneingabefeld zur Bedieneingabe und ein Sensorsystem zum Erkennen einer Bedieneingabe im Bereich des Bedieneingabefeldes aufweist. Dabei weist das Sensorsystem wenigstens eine erste, kapazitive Sensoreinrichtung mit einer ersten, elektrisch leitfähigen Sensorstruktur und eine zweite, kapazitive Sensoreinrichtung mit einer zweiten, elektrisch leitfähigen Sensorstruktur auf, wobei die Sensorstrukturen unterhalb der Bedienoberfläche im Bereich des Bedieneingabefeldes angeordnet sind.

Des Weiteren betrifft die Erfindung ein Verfahren zum Betrieb einer vorbeschriebenen Bedieneinrichtung.

Bedieneinrichtungen mit Bedienoberflächen mit Sensorsystemen mit kapazitiven Sensoreinrichtungen zur Erkennung einer Bedieneingabe sind aus dem Stand der Technik grundsätzlich bekannt. Insbesondere sind Bedieneinrichtungen mit kapazitiven Sensoreinrichtungen zur Erkennung einer Bedieneingabe bekannt, die einen Eingabebildschirm als Bedienoberfläche aufweisen, beispielsweise aus der DE 10 2011 011 769 A1, der DE 10 2007 039 609 A1 oder der US 2012/227259 A1.

Das Erkennen einer Bedieneingabe erfolgt bei kapazitiven Sensoreinrichtungen dabei nach dem sogenannten "kapazitiven Prinzip", welches darauf beruht, dass eine Annäherung einer menschlichen Hand bzw. eines Fingers, insbesondere eine Berührung der Bedienoberfläche, im Detektionsbereich der zugehörigen Sensorstrukturen eine Änderung der kapazitiven Kopplung der betreffenden Sensorstruktur mit der Umgebung und falls vorhanden, mit einer Referenzelektrode bewirkt, wobei die Änderung der kapazitiven Kopplung messtechnisch erfasst werden kann. Aus der erfassten Änderung der kapazitiven Kopplung der Sensorstruktur mit der Umgebung und/oder mit der Referenzelektrode, kann dann auf eine Bedieneingabe rückgeschlossen werden.

Zur Erfassung der kapazitiven Kopplung einer Sensorstruktur mit der Umgebung und/oder einer Referenzelektrode beziehungsweise der Änderung einer kapazitiven Kopplung stehen aus dem Stand der Technik verschiedene Verfahren zur Verfügung. Die Erfassung der kapazitiven Kopplung kann grundsätzlich beispielsweise mittels eines Schwingkreises oder mithilfe eines Ladevorgangs, bei dem beispielsweise eine Stromänderung erfasst wird, gemessen werden, oder mittels anderer, entsprechender geeigneter Methoden. Darüber hinaus ist für andere Anwendungen ein Verfahren bekannt, das von der Firma "Microchip" entwickelt worden ist, das sogenannte CVD (Capacitive-Voltage-Divider)-Verfahren, das auf einer einfachen Spannungsmessung basiert, wobei bei dem sogenannten CVD-Self-Verfahren eine Änderung der kapazitiven Kopplung der Sensorstrukturen mit der Umgebung erfasst wird und bei dem sogenannten CVD-Mutual-Verfahren, eine Änderung der kapazitiven Kopplung der Sensorstruktur mit einer Referenzelektrode.

In sicherheitsrelevanten Systemen ist es von Bedeutung, ein fehlerhaftes Verhalten der zur Signalerfassung verwendeten Sensoren oder deren Signalpfade zeitnah zu erkennen, um das System in einen sicheren Zustand überführen zu können. Dabei sind aus dem Stand der Technik unterschiedliche Fehlererkennungsmechanismen bekannt, wobei insbesondere bekannt ist, die sicherheitsrelevanten Signale redundant zu erfassen, wobei dazu üblicherweise jeweils mindestens ein zusätzlicher Sensor vorgesehen ist, dessen erwartetes Sensorsignal möglichst unabhängig erfasst und ausgewertet wird und mit dem Sensorsignal des anderen Sensors nach unterschiedlichen Methoden plausibilisiert werden kann, insbesondere durch Vergleich. Erscheint das Sensorsignal unplausibel wird ein Fehlerzustand erkannt und das System in den sicheren Zustand überführt.

Des Weiteren ist aus dem Stand der Technik bekannt, die einzelnen Sensoren gezielt zu stimulieren und die daraufhin erzeugten und erfassten Sensorsignale mit den erwarteten Signalwerten zu vergleichen und zu plausibilisieren.

Insbesondere bei Bedieneinrichtungen mit wenigstens einem Eingabebildschirm als Bedienoberfläche, vor allem bei Touch-Screens, stellt die fehlerfreie Erkennung einer Bedieneingabe eine große Herausforderung dar, da nicht wie bei mechanischen Bedieneingabegeräten oder üblichen Schaltern, eine mechanische Betätigung bewirkt wird, welche eindeutig und einfach mittels entsprechender Schalter erkannt werden kann, sondern bereits eine bloße Annäherung oder ein unbeabsichtigtes Berühren des Eingabebildschirms zu einer Änderung der kapazitiven Kopplung führen kann, auch wenn keine Bedieneingabe gewünscht ist.

Es ist Aufgabe der Erfindung, ein alternatives Bedieneingabegerät sowie ein alternatives Verfahren bereitzustellen, insbesondere ein verbessertes Bedieneingabegerät sowie ein verbessertes Verfahren, mit dem auf einfache Art und Weise die Steuerung sicherheitsrelevanter Funktionen ermöglicht wird, auch in Bedieneinrichtungen mit einem Eingabebildschirm als Bedienoberfläche, so dass die Bedieneinrichtung zur Steuerung sicherheitsrelevanter Funktionen eingesetzt werden kann.

Diese Aufgabe wird durch eine erfindungsgemäße Bedieneinrichtung sowie durch ein erfindungsgemäßes Verfahren gemäß den jeweiligen unabhängigen Patentansprüchen gelöst. Vorteilhafte Ausführungen der Erfindung sind Gegenstand der abhängigen Patentansprüche, der Beschreibung und der Figuren.

Der Rahmen der Erfindung wird durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden.

Eine erfindungsgemäße Bedieneinrichtung ist dadurch gekennzeichnet, dass die erste Sensorstruktur und die zweite Sensorstruktur zumindest in einem Teilbereich des Bedieneingabefeldes jeweils kammartig und/oder mäanderförmig ausgebildet sind und miteinander kämmend angeordnet sind.

Durch eine derartige Ausgestaltung der einzelnen Sensorstrukturen und deren kammartige Anordnung kann auf einfache Art und Weise eine besonders vorteilhafte redundante Erkennung einer Bedieneingabe erreicht werden, da jeweils zwei Sensorstrukturen im Bereich eines gemeinsamen Bedienfeldes angeordnet sind.

In einer vorteilhaften Ausgestaltung einer erfindungsgemäßen Bedieneinrichtung sind die Sensorstrukturen dabei jeweils in einer Ebene unterhalb der Bedienoberfläche im Bereich des Bedieneingabefeldes angeordnet, vorzugsweise in einer zur Bedienoberfläche parallelen Ebene, insbesondere in einer gemeinsamen Ebene.

In einer weiteren vorteilhaften Ausgestaltung einer erfindungsgemäßen Bedienungseinrichtung weist die Bedienoberfläche mehrere Bedieneingabefelder auf, wobei jedem Bedieneingabefeld ein Sensorsystem zum Erkennen einer Bedieneingabe im Bereich des zugehörigen Bedieneingabefeldes zugeordnet ist. Dabei weist jedes, einem Bedieneingabefeld zugeordnetes Sensorsystem vorzugsweise wenigstens eine erste, kapazitive Sensoreinrichtung mit einer ersten, elektrisch leitfähigen Sensorstruktur und eine zweite, kapazitive Sensoreinrichtung mit einer zweiten, elektrisch leitfähigen Sensorstruktur auf, wobei die Sensorstrukturen insbesondere jeweils unterhalb der Bedienoberfläche des zugehörigen Bedieneingabefeldes angeordnet sind und vorzugsweise zumindest in einem Teilbereich des zugehörigen Bedieneingabefeldes jeweils kammartig und/oder mäanderförmig ausgebildet sind und miteinander kämmend angeordnet sind.

Das heißt, dass bevorzugt, wenn die Bedienoberfläche mehrere Bedieneingabefelder aufweist, jedem Bedieneingabefeld ein vorbeschriebenes Sensorsystem mit wenigstens einer ersten kapazitiven Sensoreinrichtung mit einer ersten Sensorstruktur und einer zweiten kapazitiven Sensoreinrichtung mit einer zweiten Sensorstruktur zugeordnet ist, wobei die Sensorstrukturen jeweils kammartig und/oder mäanderförmig ausgebildet sind und miteinander kämmend angeordnet sind.

Bevorzugt wird dabei wenigstens eine Bedienoberfläche durch wenigstens einen Eingabebildschirm gebildet, wobei jeder Eingabebildschirm mehrere Bedieneingabefelder aufweisen kann.

Bevorzugt sind wenigstens zwei erste Sensorstrukturen oder zwei zweite Sensorstrukturen zweier Sensorsysteme miteinander elektrisch verbunden, besonders bevorzugt sind jeweils die ersten Sensorstrukturen oder die zweiten Sensorstrukturen miteinander verbunden. Dadurch kann jeweils die Sensorstruktur, welche sich über mehrere Sensorsysteme erstreckt, für mehrere Sensorsysteme als Kontrollsensor verwendet werden, wodurch eine auf besonders einfache Art und Weise eine einfache Plausibilisierung der erfassten Sensorsignale möglich ist.

In einer erfindungsgemäßen Bedieneinrichtung ist wenigstens ein Sensorsystem dazu ausgebildet, gegenüber einem Referenzzustand jeweils eine Änderung der kapazitiven Kopplung der ersten Sensorstruktur mit der Umgebung und/oder einer Referenzelektrode zu erfassen und eine Änderung der kapazitiven Kopplung der zweiten Sensorstruktur mit der Umgebung und/oder einer Referenzelektrode, insbesondere eine infolge einer Bedieneingabe im Bereich des Bedieneingabefeldes bewirkte Änderung der kapazitiven Kopplung.

In einer besonders vorteilhaften Ausgestaltung einer erfindungsgemäßen Bedieneinrichtung ist das Sensorsystem derart ausgebildet, dass zur Erfassung der Änderung der kapazitiven Kopplung wenigstens einer Sensorstruktur mit der Umgebung in einem ersten Abtastzyklus in einem ersten Schritt eine Referenzkapazität und eine von der Sensorstruktur und der Umgebung gebildete Messkapazität jeweils mit einem definierten elektrischen Potenzial aufgeladen werden können, wobei die Referenzkapazität mit einem ersten definierten Potenzial aufladbar ist und die Messkapazität mit einem zweiten, definierten elektrischen Potenzial, Ferner ist das Sensorsystem derart ausgebildet, dass in einem weiteren Schritt die Referenzkapazität und die von der Sensorstruktur und der Umgebung gebildete Messkapazität kurzgeschlossen werden können, und in einem weiteren Schritt das sich zwischen der Messkapazität und der Referenzkapazität einstellende, resultierende elektrische Potenzial als Sensorsignal erfasst werden kann, wobei sich das resultierende elektrische Potenzial in Abhängigkeit vom ersten und zweiten elektrischen Potenzial sowie in Abhängigkeit von der Größe der Referenzkapazität und in Abhängigkeit von der Größe der Messkapazität einstellt. Die Messkapazität kann dabei aufgeladen werden, indem an der Sensorstruktur ein definiertes elektrisches Potenzial angelegt wird.

Für eine besonders genaue Erfassung der Änderung der kapazitiven Kopplung der Sensorstruktur mit der Umgebung können die vorbeschriebenen ersten zwei Schritte des ersten Abtastzyklus im Einzelnen wiederholt werden.

In einer weiteren bevorzugten Ausgestaltung einer erfindungsgemäßen Bedieneinrichtung ist das Sensorsystem derart ausgebildet, dass in einem weiteren Abtastzyklus, vorzugsweise in einem zweiten und/oder in einem dritten und/oder vierten Abtastzyklus, im ersten Schritt die Referenzkapazität mit dem zweiten elektrischen Potenzial aufgeladen werden kann und die Messkapazität mit dem ersten elektrischen Potenzial, in einem weiteren Schritt die Referenzkapazität und die von der Sensorstruktur und der Umgebung gebildete Messkapazität kurzgeschlossen werden können, und in einem weiteren Schritt das sich zwischen der Messkapazität und der Referenzkapazität einstellende, resultierende elektrische Potenzial als Sensorsignal erfasst werden kann, wobei sich das resultierende elektrische Potenzial in Abhängigkeit vom ersten und zweiten Potenzial sowie in Abhängigkeit von der Größe der Referenzkapazität und in Abhängigkeit von der Größe zu der Messkapazität einstellt. Das heißt, bevorzugt werden die betreffenden Kapazitäten in einem zweiten beziehungsweise einem weiteren, sich vorzugsweise an den ersten Abtastzyklus anschließenden Abtastzyklus, umgekehrt aufgeladen. Dadurch kann die Erfassungsgenauigkeit noch weiter verbessert werden.

Besonders bevorzugt werden, insbesondere auch, die ersten beiden Schritte des zuletzt beschriebenen Abtastzyklus wiederholt, denn dadurch kann eine noch bessere Erfassungsgenauigkeit erreicht werden, insbesondere eine höhere Signalauflösung. Dies ist insbesondere vorteilhaft, wenn die interne Referenzkapazität deutlich größer ist als die externe Kapazität oder wenn die interne Referenzkapazität deutlich kleiner ist als die externe Kapazität, das heißt wenn sich Referenzkapazität und Messkapazität deutlich unterschiedliche Größen aufweisen.

In einer besonders vorteilhaften Ausgestaltung einer erfindungsgemäßen Bedieneinrichtung weist wenigstens ein Sensorsystem eine Referenzelektrode auf, insbesondere zusätzlich, wobei die Referenzelektrode mit einem definierten elektrischen Potenzial beaufschlagt werden kann und das Sensorsystem derart ausgebildet ist, dass eine Bedieneingabe im Bereich des Bedieneingabefeldes gegenüber einem Referenzzustand eine erfassbare Änderung einer kapazitiven Kopplung der Sensorstruktur mit der Referenzelektrode bewirkt. Vorzugsweise ist das Sensorsystem dazu ausgebildet, diese Änderung der kapazitiven Kopplung der Sensorstruktur mit der Referenzelektrode zu erfassen.

In einer weiteren vorteilhaften Ausgestaltung einer erfindungsgemäßen Bedieneinrichtung ist das Sensorsystem derart ausgebildet, dass in einem weiteren Abtastzyklus, vorzugsweise in einem zweiten und/oder dritten und/oder vierten Abtastzyklus, insbesondere zusätzlich, in einem ersten Schritt die Referenzelektrode mit einem definierten elektrischen Potenzial beaufschlagt werden kann, und in einem weiteren Schritt die kapazitive Kopplung wenigstens einer Sensorstruktur mit der Referenzelektrode erfasst werden kann.

In einer weiteren vorteilhaften Ausgestaltung einer erfindungsgemäßen Bedieneinrichtung ist wenigstens ein Sensorsystem dazu ausgebildet, die Änderung der kapazitiven Kopplung der Sensorstruktur einer kapazitiven Sensoreinrichtung mit der Umgebung und/oder mit einer Referenzelektrode erst zu erfassen, wenn zuvor bei der Erfassung der Änderung der kapazitiven Kopplung der Sensorstruktur der anderen kapazitiven Sensoreinrichtung mit der Umgebung und/oder mit einer Referenzelektrode eine Bedieneingabe erkannt worden ist. Das heißt mit anderen Worten, dass in einer vorteilhaften Ausgestaltung einer erfindungsgemäßen Bedieneinrichtung die Änderung der kapazitiven Kopplung beispielsweise der zweiten Sensorstruktur erst erfasst wird, wenn zuvor mittels der ersten Sensoreinrichtung eine Bedieneingabe erkannt worden ist. Auf diese Weise kann eine Weckschaltung mit nur einer Sensoreinrichtung realisiert werden, wodurch der Stromverbrauch der Bedieneinrichtung um nahezu die Hälfte reduziert werden kann, insbesondere im Standby-Betrieb.

In einer besonders vorteilhaften Ausgestaltung, insbesondere für die Steuerung sicherheitsrelevanter Funktionen, weist die Bedieneinrichtung zum Erkennen eines Fehlerzustandes wenigstens eines Sensorsystems eine Überwachungseinrichtung auf, wobei die Überwachungseinrichtung zur Plausibilisierung wenigstens eines erfassten Sensorsignals wenigstens einer Sensoreinrichtung des Sensorsystems ausgebildet ist, insbesondere zur Plausibilisierung der Sensorsignale sämtlicher Sensoreinrichtungen des Sensorsystems. Dabei erkennt die Überwachungseinrichtung einen Fehler, wenn wenigstens ein erfasstes und ausgewertetes Sensorsignal des Sensorsystems unplausibel ist, wobei die Überwachungseinrichtung vorzugsweise dazu ausgebildet ist, in Abhängigkeit wenigstens eines erfassten Sensorsignals der ersten Sensoreinrichtung und wenigstens eins erfassten Sensorsignals der zweiten Sensoreinrichtung und/oder in Abhängigkeit der unmittelbar nacheinander erfassten Änderungen der kapazitiven Kopplung einer Sensorstruktur mit der Umgebung und der kapazitiven Kopplung dieser Sensorstruktur mit der Referenzelektrode zu erkennen, ob ein Fehlerzustand vorliegt.

Das heißt mit anderen Worten, dass bevorzugt zum einen eine Plausibilisierung mittels wenigstens eines erfassten Sensorsignals der ersten Sensoreinrichtung gegenüber wenigstens einem Sensorsignal der zweiten Sensoreinrichtung und/oder auf Basis der erfassten Änderungen der kapazitiven Kopplung einer Sensorstruktur mit der Umgebung und der Referenzelektrode vorgesehen ist.

Vorzugsweise ist die Überwachungseinrichtung, insbesondere zusätzlich, dazu ausgebildet, eine gegenseitige Beeinflussung der ersten Sensoreinrichtung und der zweiten Sensoreinrichtung wenigstens eines Sensorsystems zu erkennen, insbesondere einen Kurzschluss zwischen der ersten Sensorstruktur und der zweiten Sensorstruktur, wobei die Bedieneinrichtung vorzugsweise dazu ausgebildet ist, einen Fehlerzustand auszugeben, wenn eine Beeinflussung erkannt wird.

In einer weiteren vorteilhaften Ausgestaltung einer erfindungsgemäßen Bedieneinrichtung ist die Überwachungseinrichtung dazu ausgebildet, einen unzulässigen Signalwert wenigstens eines der Sensorsignale zu erkennen, vorzugsweise sämtlicher Sensorsignale, wobei die Überwachungseinrichtung insbesondere dazu ausgebildet ist, eine Messwertbereichsüberschreitung und/oder einen unzulässigen Signalwert innerhalb eines Messwertbereiches zu erkennen. Vorzugsweise ist die Bedieneinrichtung in diesem Fall ebenfalls dazu ausgebildet einen Fehlerzustand auszugeben, wenn ein unzulässiger Signalwert erkannt wird.

In einer weiteren vorteilhaften Ausgestaltung der Bedieneinrichtung ist die Überwachungseinrichtung dazu ausgebildet, zu erkennen, ob eines der erfassten Sensorsignale länger als eine vordefinierte Zeitdauer konstant ist, das heißt sich nicht verändert hat. Diese Fehlererkennung wird in der Regel auch als Timeout-Erkennung bezeichnet, wobei vorzugsweise wenn ein Timeout erkannt wird, eine Error-Message abgesendet werden kann und das System in einen sicheren Zustand überführt werden kann.

In einer weiteren vorteilhaften Ausgestaltung einer erfindungsgemäßen Bedieneinrichtung ist ferner eine Signalfiltereinrichtung zum Filtern der erfassten Signale vorgesehen, um eine bessere Auswertequalität zu erreichen.

Ein erfindungsgemäßes Verfahren zum Betrieb einer vorbeschriebenen Bedieneinrichtung ist in Anspruch 9 definiert.

Bei einer vorteilhaften Ausführung eines erfindungsgemäßen Verfahrens werden die ersten zwei Schritte des ersten Abtastzyklus wiederholt, bevor die Referenzkapazität und die Messkapazität kurzgeschlossen werden. Dadurch kann eine besonders hohe Erfassungsgenauigkeit erreicht werden.

Bei einer weiteren vorteilhaften Ausführung eines erfindungsgemäßen Verfahrens wird in einem weiteren Abtastzyklus, vorzugsweise in einem zweiten und/oder dritten und/oder vierten Abtastzyklus, im ersten Schritt die Referenzkapazität mit dem zweiten elektrischen Potenzial aufgeladen und die Messkapazität mit dem ersten elektrischen Potenzial. In einem weiteren Schritt werden anschließen die Referenzkapazität und die von der Sensorstruktur und der Umgebung gebildete Messkapazität kurzgeschlossen und in einem weiteren Schritt das sich zwischen der Messkapazität und der Referenzkapazität einstellende, resultierende elektrische Potenzial als Sensorsignal erfasst, wobei sich das resultierende elektrische Potenzial auch in diesem Abtastzyklus in Abhängigkeit vom ersten und zweiten Potenzial sowie in Abhängigkeit von der Größe der Referenzkapazität und in Abhängigkeit von der Größe der Messkapazität einstellt.

Weist das Sensorsystem eine Referenzelektrode auf und ist das Sensorsystem derart ausgebildet, dass eine Bedieneingabe im Bereich des Bedieneingabefeldes gegenüber einem Referenzzustand eine erfassbare Änderung einer kapazitiven Kopplung der Sensorstruktur mit der Referenzelektrode bewirkt, wird vorzugsweise in einem weiteren Abtastzyklus, insbesondere in einem zweiten und/oder dritten und/oder vierten Abtastzyklus, insbesondere zusätzlich, in einem ersten Schritt die Referenzelektrode mit einem definierten elektrischen Potenzial beaufschlagt, und in einem weiteren Schritt die kapazitive Kopplung der Sensorstruktur mit der Referenzelektrode erfasst.

Besonders bevorzugt werden nacheinander, vorzugsweise im Wechsel, insbesondere alternierend, jeweils die Änderung der kapazitiven Kopplung einer Sensorstruktur mit der Umgebung und die Änderung der kapazitiven Kopplung dieser Sensorstruktur mit der Referenzelektrode erfasst.

Bei einer besonders vorteilhaften Ausführung eines erfindungsgemäßen Verfahrens wird die Änderung der kapazitiven Kopplung der Sensorstruktur einer Sensorstruktur mit der Umgebung und/oder mit einer Referenzelektrode erst erfasst, wenn zuvor mittels einer weiteren Sensoreinrichtung, insbesondere mittels der anderen kapazitiven Sensoreinrichtung, eine Bedieneingabe erkannt worden ist.

Vorzugsweise wird, wenn eine Bedieneingabe auf einem Bedieneingabefeld erkannt wird, eine dem Bedieneingabefeld zugeordnete Funktion ausgelöst, wobei die Funktion insbesondere nur ausgelöst wird, wenn kein Fehlerzustand des Sensorsystems und/oder der Bedieneinrichtung erkannt worden ist.

Weist die Bedieneinrichtung eine Überwachungseinrichtung zum Erkennen eines Fehlerzustandes wenigstens eines Sensorsystems auf, wird vorzugsweise mittels der Überwachungseinrichtung wenigstens ein Sensorsignal wenigstens einer Sensoreinrichtung wenigstens eines Sensorsystems plausibilisiert, wobei ein Fehlerzustand erkannt wird, wenn wenigstens ein erfasstes und ausgewertetes Sensorsignal unplausibel ist, wobei vorzugsweise ein Fehlerzustand erkannt wird, wenn wenigstens ein erfasstes Sensorsignal der ersten Sensoreinrichtung gegenüber wenigstens einem erfassten Sensorsignal der zweiten Sensoreinrichtung unplausibel ist und/oder wenn die unmittelbar nacheinander erfassten Änderungen der kapazitiven Kopplung wenigstens einer Sensorstruktur mit der Umgebung und der kapazitiven Kopplung dieser Sensorstruktur mit der Referenzelektrode unplausibel ist.

Weitere Merkmale der Erfindung ergeben sich aus den Ansprüchen, den Figuren und der Figurenbeschreibung. Alle vorstehenden, in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Manche der genannten Merkmale bzw. Eigenschaften betreffen sowohl eine erfindungsgemäße Bedieneinrichtung als auch ein erfindungsgemäßes Verfahren. Einige dieser Merkmale und Eigenschaften werden teilweise nur einmal beschrieben, gelten jedoch unabhängig voneinander im Rahmen technisch möglicher Ausgestaltungen sowohl für eine erfindungsgemäße Bedieneinrichtung als auch für ein erfindungsgemäßes Verfahren. Die mit Bezug auf die Bedieneinrichtung vorgestellten, bevorzugten Ausführungsformen und deren Vorteile gelten somit entsprechend auch für ein erfindungsgemäßes Verfahren und umgekehrt.

Die Erfindung wird nun anhand bevorzugter Ausführungsbeispiele näher erläutert, insbesondere unter Bezugnahme auf die beigefügten Zeichnungen.

Es zeigen:
- Fig. 1: in schematischer Darstellung einen Schnitt durch ein Ausführungsbeispiel einer erfindungsgemäßen Bedieneinrichtung,
- Fig. 2: schematisch die erfindungsgemäße Ausgestaltung und Anordnung der Sensorstrukturen der kapazitiven Sensoreinrichtungen der erfindungsgemäßen Bedieneinrichtung aus Fig. 1 in Draufsicht,
- Fig. 3: schematisch eine mögliche, alternative Ausgestaltung und Anordnung der Sensorstrukturen für ein alternatives Ausführungsbeispiel einer erfindungsgemäßen Bedieneinrichtung,
- Fig. 4 bis 6: schematisch mögliche, alternative Ausgestaltungen und Anordnungen der Sensorstrukturen für ein alternatives Ausführungsbeispiel einer erfindungsgemäßen Bedieneinrichtung,
- Fig. 7: zur Verdeutlichung der Funktionsweise der kapazitiven Sensoreinrichtung einen Ausschnitt eines schematischen Blockschaltbildes einer kapazitiven Sensoreinrichtung für eine erfindungsgemäße Bedieneinrichtung,
- Fig. 8: einen Ausschnitt eines schematischen Blockschaltbildes eines Sensorsystems der erfindungsgemäßen Bedieneinrichtung aus Fig. 1,
- Fig. 9: schematisch den Verlauf des während der Erfassung einer Änderung der kapazitiven Kopplung einer Sensorstruktur mit der Umgebung an einer Sensorstruktur der erfindungsgemäßen Bedieneinrichtung anliegenden elektrischen Potenzials,
- Fig. 10: schematisch den sich im Unterschied zu Fig. 9 ergebenden Verlauf des an der Sensorstruktur der kapazitiven Sensoreinrichtung anliegenden elektrischen Potenzials, wenn während der Erfassung der Änderung mit der kapazitiven Kopplung jeweils die Schritte T1 und T2 sowie T4 und T5 wiederholt werden,
- Fig. 11: einen vorteilhaften Verlauf eines nachgeführten elektrischen Potenzials eines aktiven Abschirmelementes,
- Fig. 12: einen besonders vorteilhaften Verlauf eines elektrischen Potenzials eines aktiven Abschirmelementes, wobei das Potenzial des Abschirmelements im Unterschied zu Fig. 10 in diesem Fall dem Verlauf des an der Sensorstruktur anliegenden elektrischen Potenzials folgt.

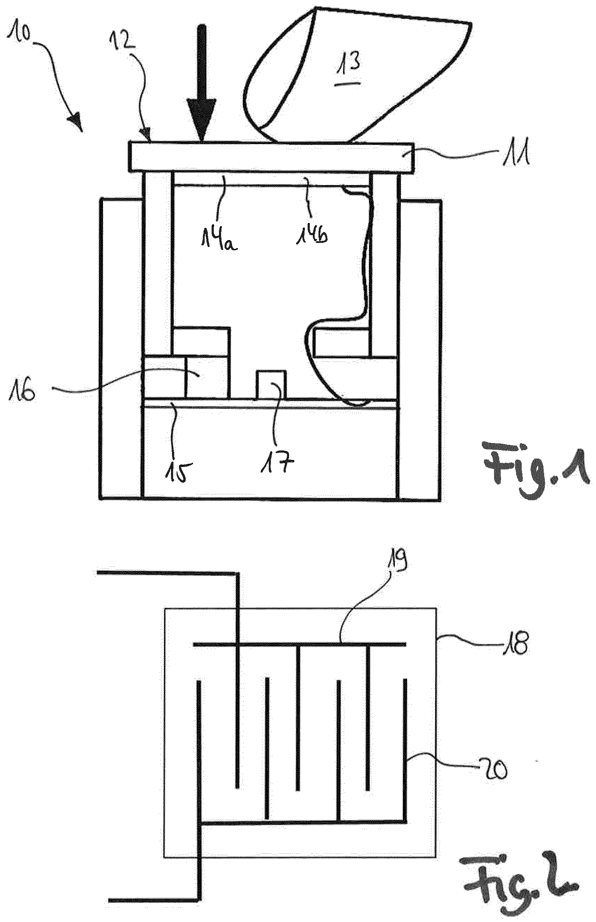

Fig. 1 zeigt ein Ausführungsbeispiel einer erfindungsgemäßen Bedieneinrichtung 10 mit einem Eingabebildschirm 11 als Bedienoberfläche 12, wobei eine Bedieneingabe durch tastendruckartiges Berühren der Bedienoberfläche 12 mit einem Finger 13 möglich ist. Die erfindungsgemäße Bedieneinrichtung 10 ist dabei zur Steuerung verschiedener, auch sicherheitsrelevanter Funktionen, in einem Fahrzeug vorgesehen.

Diese Ausführungsbeispiel einer erfindungsgemäßen Bedieneinrichtung 10 weist dabei ein Sensorsystem mit mehreren Sensoreinrichtungen 14a, 14b und 16 auf, wobei die Sensoreinrichtungen 14a und 14b jeweils kapazitive Sensoreinrichtungen 14a, 14b sind während die Sensoreinrichtung 16 eine drucksensitive Sensoreinrichtung in Form eines Kraftsensors ist.

Die Sensoreinrichtungen 14a, 14b und 16 des Sensorsystems der erfindungsgemäßen Bedieneinrichtung sind dabei jeweils mit einer Leiterplatte elektronisch gekoppelt, wobei die Leiterplatte einen hier nicht dargestellten Mikrokontroller zur Auswertung der erfassten Sensorsignale aufweist.

Anhand von Fig. 2, welche schematisch die erfindungsgemäße Ausgestaltung und Anordnung der Sensorstrukturen 19 und 20 der kapazitiven Sensoreinrichtungen der erfindungsgemäßen Bedieneinrichtung aus Fig. 1 in Draufsicht zeigt, ist erkennbar, dass die kapazitiven Sensoreinrichtungen 14a und 14b unterhalb eines den Sensoreinrichtungen 14a und 14b zugeordneten Bedieneingabefeldes 18 jeweils eine Sensorstruktur 19 bzw. 20 aufweisen, wobei der ersten kapazitive Sensoreinrichtung 14a die Sensorstruktur 19 zugeordnet ist und die Sensorstruktur 20 der kapazitiven Sensoreinrichtung 14b. Die Sensorstrukturen 19 und 20 sind dabei jeweils auf der Rückseite der die Bedienoberfläche 12 bildenden Glasplatte des Eingabebildschirms 11 aufgebracht.

Erfindungsgemäß werden dabei die erste Sensorstruktur 19 und die zweite Sensorstruktur 20 jeweils durch kammartig ausgebildete elektrische Leiter gebildet, welche in einer gemeinsamen Ebene parallel zur Bedienoberfläche 12 kämmend miteinander angeordnet sind.

Die erste Sensoreinrichtung 14a sowie die zweite kapazitive Sensoreinrichtung 14b sind dabei jeweils dazu ausgebildet, eine Berührung der Bedienoberfläche 12 in einem jeweils den beiden Sensoreinrichtungen 14a und 14b zugeordneten, gemeinsamen Bedieneingabefeld 18 zu erkennen, während die drucksensitive Sensoreinrichtung 16 nicht bereits auf bloßes Berühren der Bedienoberfläche 12 reagiert, sondern erst, wenn mittels des Fingers 13 ein einen Schwellwert überschreitender Druck auf die Bedienoberfläche 12 bzw. das zugehörige Bedieneingabefeld, aufgebracht wird.

Das Erkennen einer Bedieneingabe mittels der kapazitiven Sensoreinrichtungen 14a, 14b erfolgt dabei nach dem sogenannten "kapazitiven Prinzip", welches darauf beruht, dass eine Annäherung einer menschlichen Hand bzw. eines Fingers 13, insbesondere eine Berührung der Bedienoberfläche 12, im Detektionsbereich der zugehörigen Sensoreinrichtungen 14a, 14b eine Änderung der kapazitiven Kopplungen der betreffenden Sensorstrukturen 19, 20 mit der Umgebung und falls vorhanden, mit einer Referenzelektrode bewirkt, wobei die Änderung der kapazitiven Kopplung messtechnisch erfasst werden kann. Aus den erfassten Änderungen der kapazitiven Kopplungen der Sensorstrukturen 19, 20 mit der Umgebung und/oder mit der Referenzelektrode, kann dann auf eine Bedieneingabe rückgeschlossen werden.

Die Bedienoberfläche 12 ist bei diesem Ausführungsbeispiel einer erfindungsgemäßen Bedieneinrichtung ferner beleuchtet, wobei die Beleuchtung der Bedienoberfläche 12 durch eine rückseitig angeordnete Leuchtquelle 17 in Form einer LED erfolgt, welche dazu ausgebildet ist, die Bedienoberfläche 12 von der Rückseite her anzustrahlen, wobei die Bedienoberfläche 12 entsprechend transparent ausgebildet ist, so dass das Licht von einem Bediener auch als Beleuchtung wahrgenommen wird.

Damit die von der Leuchtquelle emittierten Lichtstrahlen nicht durch die Sensoreinrichtungen 14a und 14b, insbesondere deren Sensorstrukturen 19, 20, blockiert werden, sind diese entsprechend lichtdurchlässig ausgebildet und insbesondere aus Indiumzinnoxid hergestellt und auf die Rückseite der Bedienoberfläche 12 aufgedampft.

Die erfindungsgemäße, jeweils kammartige Ausbildung und die kämmende Anordnung der ersten Sensorstruktur 19 und der zweiten Sensorstruktur 20 unterhalb eines zugehörigen, gemeinsamen Bedieneingabefeldes 18 ermöglicht auf einfache Art und Weise eine redundante Erfassung einer Bedieneingabe, wobei die Sensorstrukturen 19 und 20 derart eng zueinander beabstandet angeordnet sind, dass jede Bedieneingabe zu einer Änderung der kapazitiven Kopplung beider Sensorstrukturen 19, 20 mit der Umgebung und/oder einer Referenzelektrode führt. Über den hier nicht näher bezeichneten Mikrokontroller auf der Leiterplatte 15 können die beiden erfassten Sensorsignale der ersten Sensoreinrichtung 14a und der zweiten Sensoreinrichtung 14b parallel ausgewertet werden. Insbesondere ist eine für sicherheitsrelevante Funktionen erforderliche, redundante Auswertung möglich, wobei die erfassten Sensorsignale zum einen miteinander verglichen werden können und zum anderen für eine gegenseitige Plausibilisierung genutzt werden können.

Die Sensorstrukturen 19 und 20 dienen dabei nicht nur zur Erfassung einer kapazitiven Kopplung mit der Umgebung und/oder einer hier nicht dargestellten Referenzelektrode, sondern können darüber hinaus zumindest jeweils als aktives Abschirmelement und als Referenzelektrode geschaltet werden.

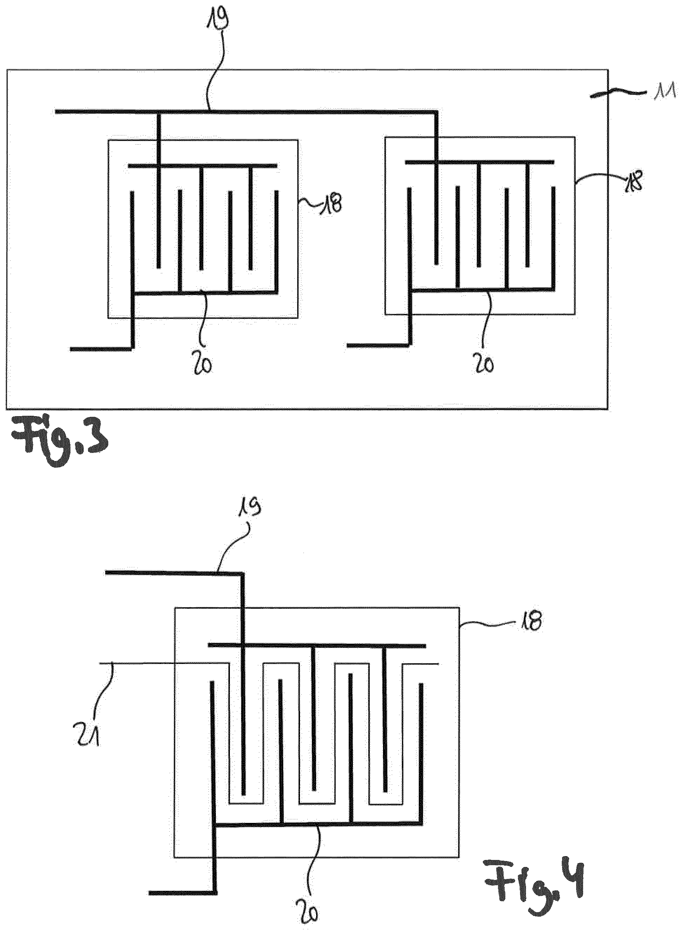

Fig. 3 zeigt schematisch eine mögliche, alternative Ausgestaltung und Anordnung der Sensorstrukturen 19 und 20 für ein alternatives Ausführungsbeispiel einer erfindungsgemäßen Bedieneinrichtung, wobei bei diesem Ausführungsbeispiel der Eingabebildschirm 11 zwei Bedieneingabefelder 18 aufweist, wobei jedem Bedieneingabefeld 18 ein Sensorsystem mit jeweils einer ersten Sensorstruktur 19 und einer zweiten Sensorstruktur 20 zugeordnet ist. Die Sensorstrukturen 19 und 20 eines Sensorsystems sind dabei jeweils unterhalb des zugehörigen Bedieneingabefeldes 18 angeordnet und jeweils kammartig ausgebildet und jeweils kämmend miteinander angeordnet, so dass in jedem Bedieneingabefeld 18 jeweils eine redundante Erfassung einer Bedieneingabe mittels der ersten Sensorstruktur 19 und der zweiten Sensorstruktur 20 möglich ist.

Zur Vereinfachung des Aufbaus einer erfindungsgemäßen Bedieneinrichtung sind jeweils die ersten Sensorstrukturen 19 miteinander verbunden, so dass nur ein Anschlusskontakt zur elektrischen Kopplung mit der Leiterplatte 15 bzw. dem Mikrokontroller erforderlich ist. Ein weiterer Vorteil einer gemeinsamen einen Sensorstruktur 19 ist, dass diese Sensorstruktur 19 gleichzeitig für sämtliche Sensorsysteme der Bedieneinrichtung 10 als Kontrollsensor dienen kann, wodurch eine besonders einfache und wirkungsvolle Plausibilisierung der erfassten Sensorsignale möglich ist.

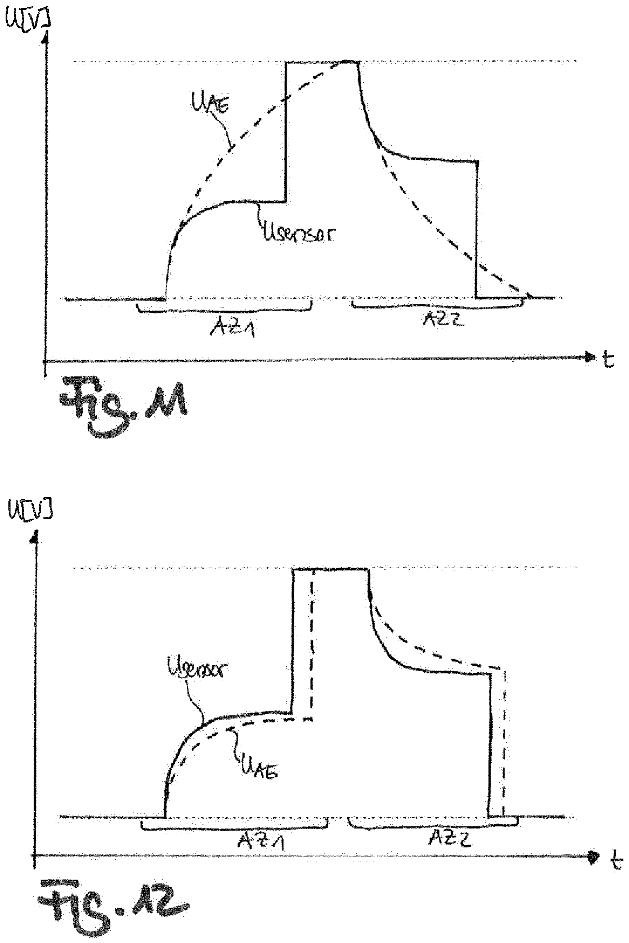

Die Fig. 4 bis 6 zeigen schematisch weitere mögliche, alternative Ausgestaltungen und Anordnungen der Sensorstrukturen 19 und 20 für eine erfindungsgemäße Bedieneinrichtung, wobei bei den in Fig. 4 gezeigten Sensorsystem zwischen der ersten Sensorstruktur 19 und der zweiten Sensorstruktur 20 ein mäanderförmig ausgebildeter, weiterer elektrischer Leiter 21 vorgesehen ist, der bei diesem Ausführungsbeispiel ebenfalls in der gleichen Ebene wie die erste Sensorstruktur 19 und die zweite Sensorstruktur 20 angeordnet ist und der als aktives Abschirmelement schaltbar ist und betrieben werden kann. Dazu kann der elektrisch Leiter 21 insbesondere mit einem definierten, elektrischen Potenzial U_{AE} beaufschlagt werden kann, das dem an einer der Sensorstrukturen 19 bzw. 20 anliegenden Sensorsignal nachgeführt ist bzw. diesem folgt, während die Änderung der kapazitiven Kopplung wenigstens einer Sensorstruktur 19 bzw. 20 mit der Umgebung und/oder einer hier nicht dargestellten Referenzelektrode erfasst wird, vgl. Fig. 11 und 12.

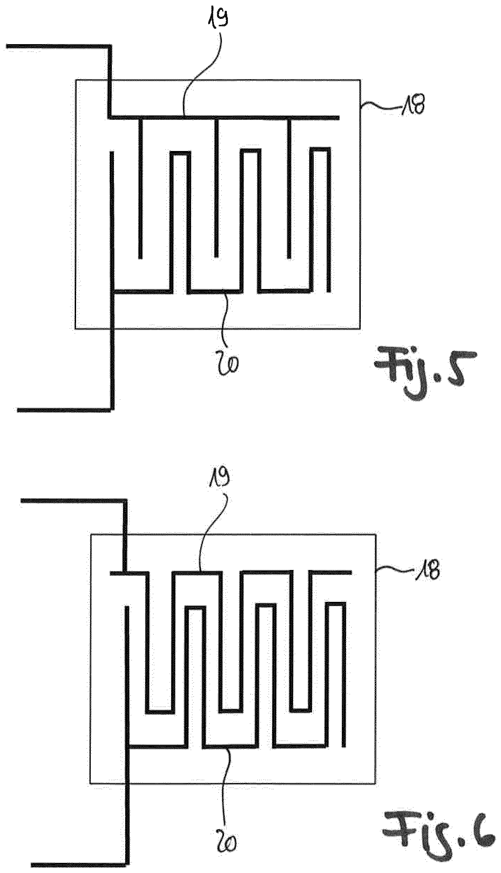

Bei den in Fig. 5 gezeigten Sensorstrukturen 19 und 20 ist im Unterschied zu den vorherigen Ausführungsbeispielen die Sensorstruktur 20 nicht kammartig ausgebildet wie die Sensorstruktur 19, sondern mäanderförmig, jedoch erfindungsgemäß ebenfalls kämmend mit der ersten Sensorstruktur 19 angeordnet.

Fig. 6 zeigt ein weiteres Ausführungsbeispiel zur Ausgestaltung und Anordnung der Sensorstrukturen 19, 20 einer erfindungsgemäßen Bedieneinrichtung, wobei in diesem Fall sowohl die erste Sensorstruktur 19 als auch die zweite Sensorstruktur 20 jeweils mäanderförmig ausgebildet sind, aber ebenfalls erfindungsgemäß miteinander kämmend angeordnet sind.

Das Erkennen einer Bedieneingabe erfolgt bei der vorbeschriebenen erfindungsgemäßem Bedieneinrichtung zum einen mittels der drucksensitiven Sensoreinrichtung 16 sowie mittes der ersten kapazitiven Sensoreinrichtung 14a und der zweiten kapazitiven Sensoreinrichtung 14b durch ein erfindungsgemäßes Verfahren.

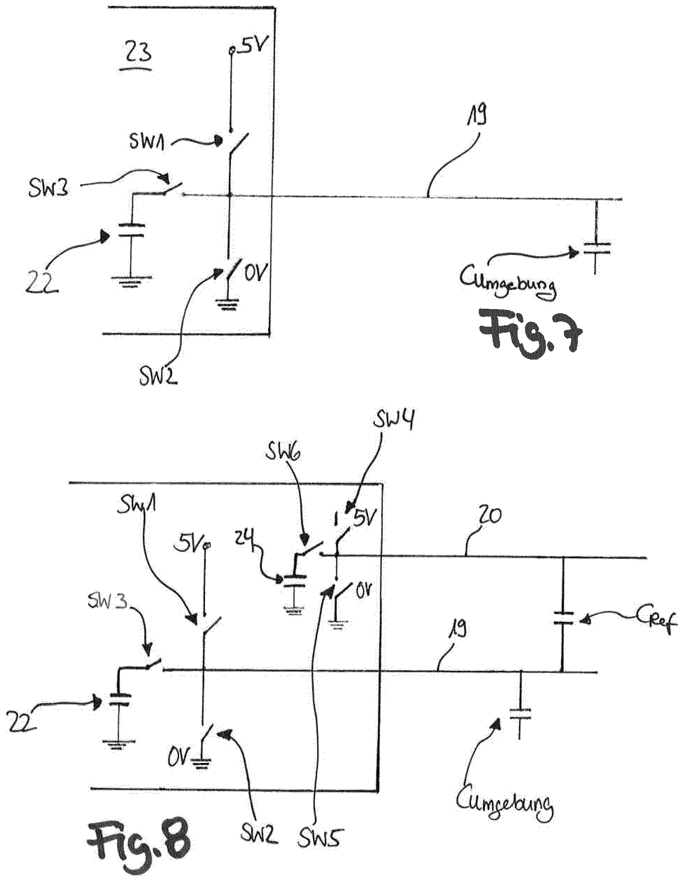

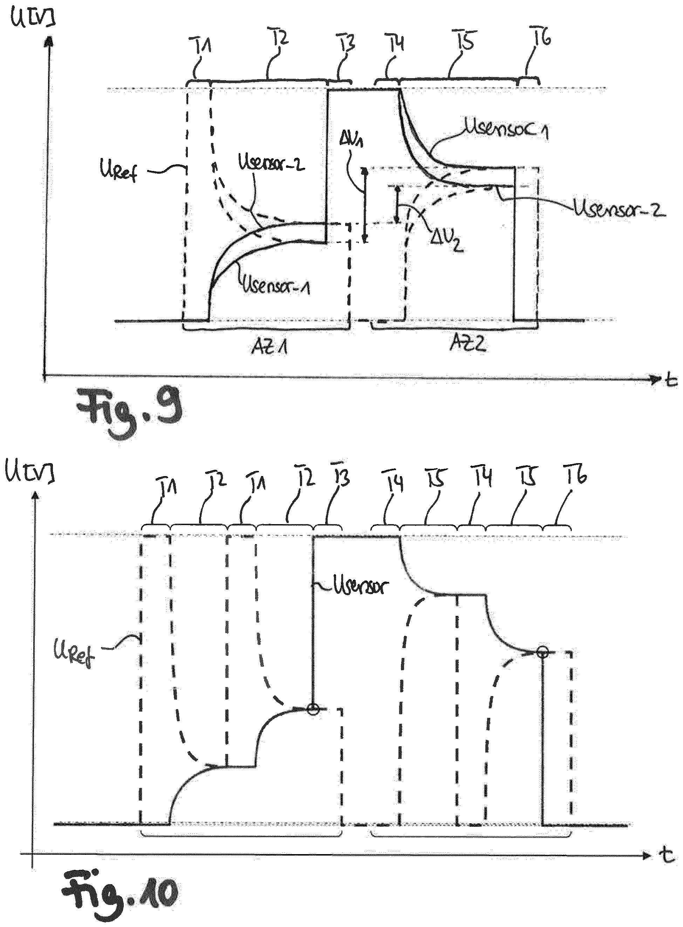

Fig. 7 zeigt zur Verdeutlichung der Funktionsweise der kapazitiven Sensoreinrichtungen 14a und 14b, insbesondere zur Erläuterung des erfindungsgemäßen Verfahrens, einen Ausschnitt eines schematischen Blockschaltbildes einer kapazitiven Sensoreinrichtung für eine erfindungsgemäße Bedieneinrichtung. Ein zugehöriger, sich bei einer Anwendung eines erfindungsgemäßen Verfahrens ergebender, beispielhafter Potenzialverlauf eines an einer Sensorstruktur 19 anliegenden Potenzials U_{Sensor} ist in Fig. 9 dargestellt.

Zum Erkennen einer Bedieneingabe, insbesondere zum Erfassen der kapazitiven Kopplung einer Sensorstruktur, gemäß eines erfindungsgemäßen Verfahrens, das im Folgenden beispielhaft anhand der Sensorstruktur 19 beschrieben wird, werden während eines ersten Abtastzyklus AZ1 in einem ersten Schritt im Zeitraum T1 die Referenzkapazität 22 und die mit der Umgebung kapazitiv gekoppelte Sensorstruktur 19 definiert aufgeladen, beispielsweise die Referenzkapazität mit 5V und die Sensorstruktur 19 wie gezeigt mit 0V, und anschließend werden in einem zweiten Schritt T2 die Referenzkapazität 22 und die Sensorstruktur 19 kurzgeschlossen. In einem dritten Schritt in einem Zeitraum T3 wird dann von einer Auswerteeinrichtung 23, welche bei diesem Ausführungsbeispiel der auf der Leiterplatte angeordnete Mikrokontroller ist, das sich zwischen der Referenzkapazität 22 und der Sensorstruktur 19 einstellende Potenzial U_{Sensor} erfasst und ausgewertet. Aus dem sich an der Sensorstruktur 19 einstellenden Potenzial U_{Sensor}, welches die kapazitive Kopplung der Sensorstruktur 19 mit der Umgebung wiedergibt, kann anschließend rückgeschlossen werden, ob sich eine menschliche Hand oder ein Finger 13 etc. im Detektionsbereich der Sensoreinrichtung 14a befindet oder nicht bzw. ob eine Bedieneingabe erfolgt ist oder nicht.

Zum Aufladen der Referenzkapazität 22 werden zunächst die Schalter SW1 und SW3 geschlossen und der Schalter SW2 geöffnet. Zum Aufladen der Messkapazität C_{Umgebung} werden die Schalter SW3 und SW1 geöffnet und der Schalter SW2 geschlossen. Ist die Messkapazität C_{Umgebung} aufgeladen, wird der Schalter SW2 anschließend ebenfalls wieder geöffnet.

Das Kurzschließen erfolgt dann durch Schließen des Schalters SW3 und bewirkt, dass sich an der Referenzkapazität 22 und der Messkapazität C_{Umgebung} das gleiche Potenzial U_{Sensor} einstellt, wobei sich das resultierende elektrische Potenzial U_{Sensor} grundsätzlich in Abhängigkeit vom ersten und zweiten elektrischen Potenzial sowie in Abhängigkeit von der Größe der Referenzkapazität 22 und in Abhängigkeit von der Größe der Messkapazität C_{Umgebung} einstellt. Ist die Messkapazität C_{Umgebung} etwa gleich groß wie die Referenzkapazität 22 stellt sich in etwa ein Potenzial U_{Sensor} mit halber Amplitude ein, d.h. in diesem Fall mit einer Amplitude von 5V stellt sich ein Potenzial an der Sensorstruktur 19 von ca. 2,5V.

Befindet sich keine menschliche Hand bzw. kein Finger 13 oder dergleichen im Detektionsbereich der Sensoreinrichtung bzw. der Sensorstruktur 19, stellt sich ein Potenzialverlauf U_{Sensor1} ein. Befindet sich hingegen eine menschliche Hand bzw. ein Finger 13 oder dergleichen im Detektionsbereich der Sensorstruktur 19, ergibt sich ein anderer Potenzialverlauf, welcher hier beispielhaft durch den Potenzialverlauf U_{Sensor2} dargestellt ist. Anhand des sich ergebenden Potenzials U_{Sensor1} bzw. U_{Sensor2} kann auf die Anwesenheit oder Abwesenheit einer menschlichen Hand 13 im Detektionsbereich der Sensorstruktur 19 geschlossen werden.

Während des Erfassens des an der Sensorstruktur 19 und an der Referenzkapazität 22 anliegenden Potenzials U_{Sensor} kann, wenn der Schalter SW3 wieder geöffnet ist, die Sensorstruktur 19 bereits wieder mit einem definierten Potenzial beaufschlagt werden, beispielsweise für eine nächste Abtastung zur Erkennung einer Bedieneingabe oder für einen anderen Zweck.

Zur weiteren Verbesserung der Erfassungsgenauigkeit können zusätzlich in einem zweiten Abtastzyklus AZ2 im ersten Schritt T4 anschließend noch die Referenzkapazität 22 mit dem zweiten elektrischen Potenzial von 0V und die Messkapazität C_{Umgebung} mit dem ersten elektrischen Potenzial von 5V aufgeladen werden, das heißt umgekehrt zum ersten Abtastzyklus AZ1.

In einem weiteren Schritt T5 werden die Referenzkapazität 22 und die von der Sensorstruktur 19 und der Umgebung gebildete Messkapazität C_{Umgebung} dann wieder kurzgeschlossen und in einem weiteren Schritt T6 kann erneut das sich zwischen der Messkapazität C_{Umgebung} und der Referenzkapazität 22 einstellende, resultierende elektrische Potenzial U_{Sensor} erfasst werden.

Dadurch erhält man Potenzialdifferenzen ΔU₁ bzw. ΔU₂, die ausgewertet werden können, anstatt absoluter Potenzialwerte U_{Sensor1} bzw. U_{Sensor2}, wodurch eine bessere Erkennungsgenauigkeit erzielt werden kann. Insbesondere ist es in diesem Fall nicht mehr erforderlich sich auf die absoluten Potenzialwerte U_{Sensor1} bzw. U_{Sensor2} auswirkende, störende, stationäre, kapazitive Kopplungen zu korrigieren bzw. herauszurechnen bzw. die Sensoreinrichtung 14a, 14b diesbezüglich entsprechend zu kalibrieren.

Zur Erhöhung der Erfassungsgenauigkeit, insbesondere zur Verbesserung der Auflösung bei unterschiedlich großer Mess- und Referenzkapazität 22, ist es vorteilhaft, jeweils die ersten beiden Schritte T1 und T2 sowie T4 und T5 des ersten Abtastzyklus AZ1 und des zweiten Abtastzyklus AZ2 zu wiederholen, siehe Fig. 10, da sich auf diese Weise das resultierende Potenzial U_{Sensor} der halben Potenzialdifferenz annähert.

Fig. 8 zeigt einen Ausschnitt eines schematischen Blockschaltbildes der kapazitiven Sensoreinrichtungen 14a und 14b der erfindungsgemäßen Bedieneinrichtung 10 aus Fig. 1, wobei im Unterschied zur der lediglich zur Erläuterung dienenden Darstellung in Fig. 7, bei der erfindungsgemäßen Bedieneinrichtung 10 die Sensorstruktur 20 zusätzlich mittels der Schalter SW4, SW5 und SW6 als Referenzelektrode 20 schaltbar ist und mit einem definierten elektrischen Potenzial beaufschlagt werden kann, so dass die kapazitive Kopplung der ersten Sensorstruktur 19 mit einer Referenzelektrode, welche in diesem Fall durch die zweite Sensorstruktur 20 gebildet wird, erfasst werden kann, wobei eine Bedieneingabe im Detektionsbereich der ersten Sensorstruktur 19 einem Referenzzustand gegenüber eine erfassbare, der Sensorstruktur 19 zugeordnete Änderung einer kapazitiven Kopplung C_{Ref} der Sensorstruktur 19 mit der Referenzelektrode 20 bewirkt.

Dabei hat es sich als besonders vorteilhaft herausgestellt, wenn die Referenzelektrode 20 in einem weiteren Abtastzyklus, insbesondere in einem zweiten Abtastzyklus AZ2 und/oder einem dritten und/oder vierten Abtastzyklus hinzugeschaltet wird, da dies bei entsprechend gewähltem, an der Referenzelektrode 20 anliegendem Potenzial eine Vergrößerung der Potenzialdifferenz ΔU₁ bzw. ΔU₂ bewirkt, wodurch eine bessere Auflösung und somit eine höhere Erkennungsgenauigkeit erreicht werden kann. Das heißt, die Potenzialverläufe U_{Sensor1} bzw. U_{Sensor2} liegen dann auf einem anderen Niveau.

Besonders vorteilhaft ist es, wenn unmittelbar nacheinander, insbesondere im Wechsel, besonders bevorzugt alternierend, die Änderung der kapazitiven Kopplung der Sensorstruktur 19 mit der Umgebung und die Änderung der kapazitiven Kopplung der Sensorstruktur 19 mit der Referenzelektrode 20 erfasst werden. Dadurch lässt sich eine besonders hohe Erkennungsgenauigkeit erreichen, da eine Vielzahl an Potenzialwerten U_{Sensor1} bzw. U_{Sensor2} bzw. Potenzialdifferenzen ΔU₁ bzw. ΔU₂ zur Verfügung steht, welche nahezu beliebig miteinander verrechnet werden können, um Messfehler und stationäre Offsets oder dergleichen herauszurechnen bzw. zu kompensieren und/oder die Auflösung und damit die Genauigkeit bzw. die Empfindlichkeit der Sensoreinrichtung zu erhöhen.

Vorzugsweise wird jeweils alternierend im Wechsel die kapazitive Kopplung der ersten Sensorstruktur 19 mit der Umgebung und einer Referenzelektrode erfasst, wobei die zweite Sensorstruktur 20 die Referenzelektrode bildet, und anschließend, jedoch nur derart kurz zeitlich versetzt nacheinander, dass eine für sicherheitsrelevante Funktionen erforderliche Plausibilisierung der Sensorsignale der ersten und der zweiten Sensoreinrichtung weiterhin möglich ist, die kapazitive Kopplung der zweiten Sensorstruktur 20 mit der Umgebung und einer Referenzelektrode, wobei in diesem Fall die erste Sensorstruktur 19 die Referenzelektrode bildet.

Weist eine erfindungsgemäße Bedieneinrichtung ein zusätzliches Abschirmelement auf, beispielsweise wie in Fig. 4 dargestellt in Form eines weiteren elektrischen Leiters 21 oder eine als Abschirmelement betreibbare Sensorstruktur, wird das Abschirmelement vorzugsweise während der Erfassung der kapazitiven Kopplung einer Sensorstruktur mit der Umgebung und/oder einer Referenzelektrode mit einem definierten elektrischen Potenzial beaufschlagt, insbesondere mit einem dem an der betreffenden Sensorstruktur anliegenden Potenzial nachgeführten oder folgenden Potenzial U_{AE}, siehe Fig. 11 und 12, wobei Fig. 11 schematisch einen beispielhaften, vorteilhaften Verlauf eines nachgeführten elektrischen Potenzials U_{AE} zeigt, mit dem ein aktives Abschirmelement beaufschlagt werden kann.

Dabei nimmt das Potenzial U_{AE} zu, wenn das an der Sensorstruktur anliegende Potenzial U_{Sensor} zunimmt und ab, wenn das an der Sensorstruktur anliegende Potenzial U_{Sensor} abnimmt. Mit einer derartigen Beaufschlagung eines Abschirmelementes kann bereits eine gute Abschirmleistung erreicht werden.

Ein derartiger Potenzialverlauf U_{AE} kann zum Beispiel durch die Verwendung eines Sensorsystems mit einem Mikrocontroller von der Firma "Microchip" erreicht werden, indem das betreffende Abschirmelement elektrisch mit einem speziell dafür vorgesehenen I/O-Pin am Mikrocontroller angeschlossen wird. Der Mikrocontroller ist entsprechend dazu ausgebildet, diesen Pin in Abhängigkeit vom Zustand der Sensoreinrichtung mit dem gezeigten Potenzialverlauf zu belegen.

Für eine noch bessere Abschirmung, sollte das definierte elektrische Potenzial U_{AE}, mit welchem das Abschirmelement beaufschlagt wird, dem an der Sensorstruktur anliegenden elektrischen Potenzial U_{Sensor} möglichst gut folgen, vorzugsweise wie in Fig. 12 dargestellt. Fig. 12 zeigt schematisch den Verlauf eines elektrischen Potenzials U_{AE} eines aktiven Abschirmelementes, das nahezu den gleichen Kurvenverlauf mit nahezu gleichen absoluten Potenzialwerten aufweist wie das an der Sensorstruktur anliegende elektrische Potenzial U_{Sensor} und somit dem Verlauf des an der Sensorstrukturanliegenden elektrischen Potenzials U_{Sensor} folgt.

Dieser Potenzialverlauf U_{AE} kann ebenfalls durch die Verwendung eines Sensorsystems mit einem Mikrocontroller von der Firma "Microchip" erreicht werden, wobei das betreffende Abschirmelement in diesem Fall an einen anderen, dafür vorgesehenen Pin am Mikrocontroller angeschlossen wird, und zwar am sogenannten "DACOUT"-Pin. Der Mikrocontroller ist entsprechend dazu ausgebildet, diesen Pin in Abhängigkeit vom Zustand der Sensoreinrichtung mit dem gezeigten Potenzialverlauf zu belegen.

Selbstverständlich ist eine Vielzahl an Abwandlungen, insbesondere konstruktiver Art, möglich, ohne den Umfang der Patentansprüche zu verlassen.

## Patentansprüche

1. Bedieneinrichtung (10) für ein Fahrzeug, insbesondere eine Bedieneinrichtung (10) zur Steuerung sicherheitsrelevanter Funktionen, wobei die Bedieneinrichtung (10)
- wenigstens eine Bedienoberfläche (12) mit wenigstens einem Bedieneingabefeld (18) zur Bedieneingabe und
- ein Sensorsystem zum Erkennen einer Bedieneingabe im Bereich des Bedieneingabefeldes (18) aufweist,
wobei das Sensorsystem wenigstens eine erste, kapazitive Sensoreinrichtung (14a) mit einer ersten, elektrisch leitfähigen Sensorstruktur (19) und eine zweite, kapazitive Sensoreinrichtung (14b) mit einer zweiten, elektrisch leitfähigen Sensorstruktur (20) aufweist, wobei die Sensorstrukturen (19, 20) unterhalb der Bedienoberfläche (12) im Bereich des Bedieneingabefeldes (18) angeordnet sind,
und die erste Sensorstruktur (19) und die zweite Sensorstruktur (20) zumindest in einem Teilbereich des Bedieneingabefeldes (18) jeweils kammartig und/oder mäanderförmig ausgebildet sind und miteinander kämmend angeordnet sind, **dadurch gekennzeichnet, dass**
das Sensorsystem dazu ausgebildet ist, gegenüber einem Referenzzustand jeweils eine Änderung der kapazitiven Kopplung der ersten Sensorstruktur (10) mit der Umgebung und/oder einer Referenzelektrode und eine Änderung der kapazitiven Kopplung der zweiten Sensorstruktur (20) mit der Umgebung und/oder der Referenzelektrode zu erfassen, insbesondere eine infolge einer Bedieneingabe im Bereich des Bedieneingabefeldes (18) bewirkte Änderung der kapazitiven Kopplung, und dass das Sensorsystem dazu ausgebildet ist, die Änderung der kapazitiven Kopplung der Sensorstruktur (19) der ersten kapazitiven Sensoreinrichtung (14a) und der Sensorstruktur (20) der zweiten Sensoreinrichtung (14b) des Sensorsystems mit der Umgebung und/oder mit der Referenzelektrode gleichzeitig zu erfassen oder derart zeitlich kurz nacheinander versetzt zu erfassen, dass eine sicherheitsrelevante Plausibilisierung der erfassten Sensorsignale möglich ist.

2. Bedieneinrichtung (10) nach Anspruch 1, **dadurch gekennzeichnet, dass** wenigstens zwei erste Sensorstrukturen (19) oder zwei zweite Sensorstrukturen (20) zweier Sensorsysteme miteinander elektrisch verbunden sind.

3. Bedieneinrichtung (10) nach Anspruch 1 oder 2, **dadurch gekennzeichnet, dass** das Sensorsystem derart ausgebildet ist, dass zur Erfassung der Änderung der kapazitiven Kopplung wenigstens einer Sensorstruktur (19, 20) mit der Umgebung in einem ersten Abtastzyklus (AZ1) in einem ersten Schritt (T1) eine Referenzkapazität (22)und eine von der Sensorstruktur (19, 20) und der Umgebung gebildete Messkapazität (C_{Umgebung}) jeweils mit einem definierten elektrischen Potenzial aufladbar sind, wobei die Referenzkapazität (22) mit einem ersten, definierten elektrischen Potenzial aufladbar ist und die Messkapazität (C_{Umgebung}) mit einem zweiten, definierten elektrischen Potenzial, in einem weiteren Schritt (T2) die Referenzkapazität (22) und die von der Sensorstruktur (19, 20) und der Umgebung gebildete Messkapazität (C_{Umgebung}) kurzschließbar sind, und in einem weiteren Schritt das sich zwischen der Messkapazität (C_{Umgebung}) und der Referenzkapazität (22) einstellende, resultierende elektrische Potenzial (U_{Sensor}) als Sensorsignal erfassbar ist, wobei sich das resultierende elektrische Potenzial (U_{Sensor}) in Abhängigkeit vom ersten und zweiten elektrischen Potenzial sowie in Abhängigkeit von der Größe der Referenzkapazität (22) und in Abhängigkeit von der Größe der Messkapazität (C_{Umgebung}) einstellt.

4. Bedieneinrichtung (10) nach Anspruch 3, **dadurch gekennzeichnet, dass** das Sensorsystem derart ausgebildet ist, dass in einem weiteren Abtastzyklus (AZ2), vorzugsweise in einem zweiten und/oder dritten und/oder vierten Abtastzyklus, im ersten Schritt (T4) die Referenzkapazität (22) mit dem zweiten elektrischen Potenzial aufladbar ist und die Messkapazität (C_{Umgebung}) mit dem ersten elektrischen Potenzial, in einem weiteren Schritt (T₅) die Referenzkapazität (22) und die von der wenigstens einen Sensorstruktur (19, 20) und der Umgebung gebildete Messkapazität (C_{Umgebung}) kurzschließbar sind, und in einem weiteren Schritt (T6) das sich zwischen der Messkapazität (C_{Umgebung}) und der Referenzkapazität (22) einstellende, resultierende elektrische Potenzial (U_{Sensor}) als Sensorsignal erfassbar ist, wobei sich das resultierende elektrische Potenzial (U_{Sensor}) in Abhängigkeit vom ersten und zweiten Potenzial sowie in Abhängigkeit von der Größe der Referenzkapazität (22) und in Abhängigkeit von der Größe der Messkapazität (C_{Umgebung}) einstellt.

5. Bedieneinrichtung (10) nach wenigstens einem der vorgenannten Ansprüche **dadurch gekennzeichnet, dass** wenigstens ein Sensorsystem eine Referenzelektrode (20) aufweist, wobei die Referenzelektrode (20) mit einem definierten elektrischen Potenzial beaufschlagbar ist und das Sensorsystem derart ausgebildet ist, dass eine Bedieneingabe im Bereich des Bedieneingabefeldes (18) gegenüber einem Referenzzustand eine erfassbare Änderung einer kapazitiven Kopplung wenigstens einer Sensorstruktur (19, 20) mit der Referenzelektrode (20) bewirkt.

6. Bedieneinrichtung (10) nach Anspruch 5, **dadurch gekennzeichnet, dass** das Sensorsystem derart ausgebildet ist, dass in einem weiteren Abtastzyklus (AZ₂), vorzugsweise in einem zweiten und/oder dritten und/oder vierten Abtastzyklus, insbesondere zusätzlich, in einem ersten Schritt die Referenzelektrode (20) mit einem definierten elektrischen Potenzial beaufschlagbar ist, und in einem weiteren Schritt die kapazitive Kopplung wenigstens einer Sensorstruktur (19) mit der Referenzelektrode (20) erfassbar ist.

7. Bedieneinrichtung (10) nach wenigstens einem der vorgenannten Ansprüche, **dadurch gekennzeichnet, dass** wenigstens ein Sensorsystem dazu ausgebildet ist, die Änderung der kapazitiven Kopplung der Sensorstruktur (20) einer kapazitiven Sensoreinrichtung (14b) mit der Umgebung und/oder mit einer Referenzelektrode erst zu erfassen, wenn zuvor bei der Erfassung der Änderung der kapazitiven Kopplung der Sensorstruktur (19) der anderen Sensoreinrichtung (14a) mit der Umgebung und/oder mit einer Referenzelektrode eine Bedieneingabe erkannt worden ist.

8. Bedieneinrichtung (10) nach wenigstens einem der vorgenannten Ansprüche, **dadurch gekennzeichnet, dass** die Bedieneinrichtung (10) zum Erkennen eines Fehlerzustands wenigstens eines Sensorsystems eine Überwachungseinrichtung aufweist, wobei die Überwachungseinrichtung zur Plausibilisierung wenigstens eines erfassten Sensorsignals wenigstens einer Sensoreinrichtung des Sensorsystems ausgebildet ist, insbesondere zur Plausibilisierung der Sensorsignale sämtlicher Sensoreinrichtungen des Sensorsystems, wobei die Überwachungseinrichtung einen Fehler erkennt, wenn wenigstens ein erfasstes und ausgewertetes Sensorsignal des Sensorsystems unplausibel ist, wobei die Überwachungseinrichtung vorzugsweise dazu ausgebildet ist, in Abhängigkeit wenigstens eines erfassten Sensorsignals der ersten Sensoreinrichtung und wenigstens eines erfassten Sensorsignals der zweiten Sensoreinrichtung und/oder in Abhängigkeit der unmittelbar nacheinander erfassten Änderungen der kapazitiven Kopplung einer Sensorstruktur (19, 20) mit der Umgebung und der kapazitiven Kopplung dieser Sensorstruktur (19, 20) mit der Referenzelektrode zu erkennen, ob ein Fehlerzustand vorliegt.

9. Verfahren zum Betrieb einer Bedieneinrichtung (10), zum Betrieb einer Bedieneinrichtung (10), die nach wenigstens einem der Ansprüche 1 bis 8 ausgebildet ist, wobei die Bedieneinrichtung (10) wenigstens eine Bedienoberfläche (12) mit wenigstens einem Bedieneingabefeld (18) zur Bedieneingabe und ein Sensorsystem zum Erkennen einer Bedieneingabe im Bereich des Bedieneingabefeldes (18) aufweist, wobei das Sensorsystem wenigstens eine erste, kapazitive Sensoreinrichtung (14a) mit einer ersten, elektrisch leitfähigen Sensorstruktur (19) und eine zweite, kapazitive Sensoreinrichtung (14b) mit einer zweiten, elektrisch leitfähigen Sensorstruktur (20) aufweist, wobei die Sensorstrukturen (19, 20) unterhalb der Bedienoberfläche (12) im Bereich des Bedieneingabefeldes (18) angeordnet sind,
wobei zum Erkennen einer Bedieneingabe die Änderung der kapazitiven Kopplung der ersten Sensorstruktur (19) mit der Umgebung und/oder einer Referenzelektrode und eine Änderung der kapazitiven Kopplung der zweiten Sensorstruktur (20) mit der Umgebung und/oder der Referenzelektrode erfasst wird, **dadurch gekennzeichnet, dass**
wenigstens die Änderung der kapazitiven Kopplung der Sensorstruktur (19) der ersten kapazitiven Sensoreinrichtung (14a) und der Sensorstruktur (20) der zweiten Sensoreinrichtung (14b) des Sensorsystems mit der Umgebung und/oder mit der Referenzelektrode gleichzeitig oder derart zeitlich kurz nacheinander versetzt erfasst werden, dass eine sicherheitsrelevante Plausibilisierung der erfassten Sensorsignale möglich ist, wobei eine Bedieneingabe in einem Bedieneingabefeld (18) mit allen Sensoreinrichtungen (14a, 14b, 16) des Sensorsystems des zugehörigen Bedieneingabefeldes (18) gleichzeitig oder zeitlich kurz nacheinander versetzt erfasst wird.

10. Verfahren nach Anspruch 9, **dadurch gekennzeichnet, dass** zur Erfassung der Änderung der kapazitiven Kopplung wenigstens einer Sensorstruktur (19, 20) mit der Umgebung in einem ersten Abtastzyklus (AZ1) in einem ersten Schritt (T1) eine Referenzkapazität (22) und eine von der Sensorstruktur (19, 20) und der Umgebung gebildete Messkapazität (C_{Umgebung}) jeweils mit einem definierten elektrischen Potenzial aufgeladen werden, wobei die Referenzkapazität (22) mit einem ersten, definierten elektrischen Potenzial aufgeladen wird und die Messkapazität (C_{Umgebung}) mit einem zweiten, definierten elektrischen Potenzial, in einem weiteren Schritt (T2) die Referenzkapazität (22) und die von der Sensorstruktur (19, 20) und der Umgebung gebildete Messkapazität (C_{Umgebung}) kurzgeschlossen werden, und in einem weiteren Schritt das sich zwischen der Messkapazität (C_{Umgebung}) und der Referenzkapazität (22) einstellende, resultierende elektrische Potenzial (U_{Sensor}) als Sensorsignal erfasst wird, wobei sich das resultierende elektrische Potenzial (U_{Sensor}) in Abhängigkeit vom ersten und zweiten elektrischen Potenzial sowie in Abhängigkeit von der Größe der Referenzkapazität (22) und in Abhängigkeit von der Größe der Messkapazität (C_{Umgebung}) einstellt

11. Verfahren nach Anspruch 10, **dadurch gekennzeichnet, dass** in einem weiteren Abtastzyklus (AZ₂), vorzugsweise in einem zweiten Abtastzyklus, im ersten Schritt (T₄) die Referenzkapazität mit dem zweiten elektrischen Potenzial aufgeladen wird und die Messkapazität (C_{Umgebung}) mit dem ersten elektrischen Potenzial, in einem weiteren Schritt (T₅) die Referenzkapazität und die von der wenigstens einen Sensorstruktur und der Umgebung gebildete Messkapazität (C_{Umgebung}) kurzgeschlossen werden, und in einem weiteren Schritt (T₆) das sich zwischen der Messkapazität (C_{Umgebung}) und der Referenzkapazität einstellende, resultierende elektrische Potenzial (U_{Sensor}) als Sensorsignal erfasst wird, wobei sich das resultierende elektrische Potenzial (U_{Sensor}) in Abhängigkeit vom ersten und zweiten Potenzial sowie in Abhängigkeit von der Größe der Referenzkapazität und in Abhängigkeit von der Größe der Messkapazität (C_{Umgebung}) einstellt.

12. Verfahren nach Anspruch 10 oder 11, wobei wenigstens ein Sensorsystem der Bedieneinrichtung (10) eine Referenzelektrode (20) aufweist und das Sensorsystem derart ausgebildet ist, dass eine Bedieneingabe im Bereich des Bedieneingabefeldes (18) gegenüber einem Referenzzustand eine erfassbare Änderung einer kapazitiven Kopplung wenigstens einer Sensorstruktur (19) mit der Referenzelektrode (20) bewirkt,
**dadurch gekennzeichnet, dass**
in einem weiteren Abtastzyklus (AZ2), vorzugsweise in einem zweiten und/oder dritten und/oder vierten Abtastzyklus, insbesondere zusätzlich, in einem ersten Schritt die Referenzelektrode (20) mit einem definierten elektrischen Potenzial beaufschlagt wird, und in einem weiteren Schritt die kapazitive Kopplung der Sensorstruktur (19) mit der Referenzelektrode (20) erfasst wird.

13. Verfahren nach wenigstens einem der Ansprüche 10 bis 12, **dadurch gekennzeichnet, dass** die Änderung der kapazitiven Kopplung der Sensorstruktur (20) einer Sensoreinrichtung (14b) mit der Umgebung und/oder mit einer Referenzelektrode erst erfasst wird, wenn zuvor bei der Erfassung der Änderung der kapazitiven Kopplung der Sensorstruktur (19) der anderen Sensoreinrichtung (14a) mit der Umgebung und/oder mit einer Referenzelektrode eine Bedieneingabe erkannt worden ist.

14. Verfahren nach wenigstens einem der Ansprüche 10 bis 13, **dadurch gekennzeichnet, dass** wenn eine Bedieneingabe auf einem Bedieneingabefeld (18) erkannt wird, eine dem Bedieneingabefeld (18) zugeordnete Funktion ausgelöst wird, wobei die Funktion vorzugsweise nur ausgelöst wird, wenn kein Fehlerzustand des Sensorsystem erkannt worden ist.

15. Verfahren nach wenigstens einem der Ansprüche 10 bis 14, wobei die Bedieneinrichtung (10) eine Überwachungseinrichtung zum Erkennen eines Fehlerzustands wenigstens eines Sensorsystems aufweist,
**dadurch gekennzeichnet, dass**
mittels der Überwachungseinrichtung wenigstens ein Sensorsignal wenigstens einer Sensoreinrichtung (14a, 14b, 16) wenigstens eines Sensorsystems plausibilisiert wird, wobei ein Fehlerzustand erkannt wird, wenn wenigstens ein erfasstes und ausgewertetes Sensorsignal unplausibel ist, wobei vorzugsweise ein Fehlerzustand erkannt wird, wenn wenigstens ein erfasstes Sensorsignal der ersten Sensoreinrichtung (14a) gegenüber wenigstens einem erfassten Sensorsignal der zweiten Sensoreinrichtung (14b) unplausibel ist und/oder wenn die unmittelbar nacheinander erfassten Änderungen der kapazitiven Kopplung wenigstens einer Sensorstruktur (19, 20) mit der Umgebung und der kapazitiven Kopplung dieser Sensorstruktur (19, 20) mit der Referenzelektrode unplausibel sind.

## Claims

1. Operator control device (10) for a vehicle, in particular an operator control device (10) for controlling safety-relevant functions, wherein the operator control device (10) has
- at least one operator control interface (12) with at least one operator control input field (18) for making an operator control input, and
- a sensor system for detecting an operator control input in the vicinity of the operator control input field (18),
wherein the sensor system has at least a first capacitive sensor device (14a) with a first, electrically conductive sensor structure (19) and a second capacitive sensor device (14b) with a second, electrically conductive sensor structure (20), wherein the sensor structures (19, 20) are arranged underneath the operator control interface (12) in the vicinity of the operator control input field (18),
and the first sensor structure (19) and the second sensor structure (20) are each formed in a chamber-like fashion and/or meandering fashion at least in a part of the operator control input field (18) and are arranged so as to mesh with one another,
**characterized in that**
the sensor system is designed to sense, in comparison with a reference state, a respective change in the capacitive coupling of the first sensor structure (10) to the surroundings and/or to a reference electrode and a change in the capacitive coupling of the second sensor structure (20) to the surroundings and/or to the reference electrode, in particular a change in the capacitive coupling which is brought about by an operator control input in the region of the operator control input field (18), and **in that** the sensor system is designed to sense the change in the capacitive coupling of the sensor structure (19) of the first capacitive sensor device (14a) and the change in the capacitive coupling of the sensor structure (20) of the second sensor device (14b) of the sensor system to the surroundings and/or simultaneously to sense the reference electrode or to sense said changes with a short delay one after the other such that safety-relevant plausibility checking of the sensed sensor signals is possible.

2. Operator control device (10) according to Claim 1, **characterized in that** at least two first sensor structures (19) or two second sensor structures (20) of two sensor systems are connected electrically to one another.

3. Operator control device (10) according to Claim 1 or 2, **characterized in that** the sensor system is embodied in such a way that, in order to sense the change in the capacitive coupling of at least one sensor structure (19, 20) to the surroundings, in a first sampling cycle (AZ1), in a first step (T1) a reference capacitance (22) and a measuring capacitance (C_{Surroundings}) formed by the sensor structure (19, 20) and the surroundings can be respectively charged with a defined electrical potential, wherein the reference capacitance (22) can be charged with a first, defined electrical potential, and the measuring capacitance (C_{Surroundings}) can be charged with a second, defined electrical potential, in a further step (T2) the reference capacitance (22) and the measuring capacitance (C_{Surroundings}) formed by the sensor structure (19, 20) and the surroundings can be short-circuited, and in a further step the resulting electrical potential (U_{Sensor}) which comes about between the measuring capacitance (C_{Surroundings}) and the reference capacitance (22) can be sensed as a sensor signal, and wherein the resulting electrical potential (U_{Sensor}) comes about as a function of the first and second electrical potential and as a function of the magnitude of the reference capacitance (22) and as a function of the magnitude of the measuring capacitance (C_{Surroundings}).

4. Operator control device (10) according to Claim 3, **characterized in that** the sensor system is embodied in such a way that in a further sampling cycle (AZ2), preferably in a second and/or third and/or fourth sampling cycle, in the first step (T4) the reference capacitance (22) can be charged with the second electrical potential and the measuring capacitance (C_{Surroundings}) can be charged with the first electrical potential, in a further step (T₅) the reference capacitance (22) and the measuring capacitance (C_{Surroundings}) formed by the at least one sensor structure (19, 20) and the surroundings can be short-circuited, and in a further step (T6) resulting electrical potential (U_{Sensor}) which comes about between the measuring capacitance (C_{Surroundings}) and the reference capacitance (22) can be sensed as a sensor signal, wherein the resulting electrical potential (U_{Sensor}) comes about as a function of the first and second potential and as a function of the magnitude of the reference capacitance (22) and as a function of the magnitude of the measuring capacitance (C_{Surroundings}).

5. Operator control device (10) according to at least one of the preceding claims, **characterized in that** at least one sensor signal has a reference electrode (20), wherein a defined electrical potential can be applied to the reference electrode (20), and the sensor system is embodied in such a way that an operator control input in the region of the operator control input field (18) brings about in comparison with a reference state, a perceptible change in a capacitive coupling of at least one sensor structure (19) to the reference electrode (20).

6. Operator control device (10) according to Claim 5, **characterized in that** the sensor system is embodied in such a way that in a further sample cycle (AZ₂), preferably in a second and/or third and/or fourth sampling cycle, in particular additionally, in a first step a defined electrical potential can be applied to the reference electrode (20), and in a further step the capacitance coupling of at least one sensor structure (19) to the reference electrode (20) can be sensed.

7. Operator control device (10) according to at least one of the preceding claims, **characterized in that** at least one sensor system is designed to sense the change in the capacitive coupling of the sensor structure (20) of a capacitive sensor device (14b) to the surroundings and/or to a reference electrode only if an operator control input has been previously detected when the change in the capacitive coupling of the sensor structure (19) of the other sensor device (14a) to the surroundings and/or to a reference electrode is sensed.

8. Operator control device (10) according to at least one of the preceding claims, **characterized in that** the operator control device (10) has a monitoring device for detecting a fault state of at least one sensor system, wherein the monitoring device is designed to check the plausibility of at least one sensed sensor signal of at least one sensor device of the sensor system, in particular to check the plausibility of the sensor signals of all the sensor devices of the sensor system, wherein the monitoring device detects a fault if at least one sensed and evaluated sensor signal of the sensor system is implausible, wherein the monitoring device is preferably designed to detect whether a fault state is present, as a function of at least one sensed sensor signal of the first sensor device and at least one sensed sensor signal of the second sensor device and/or as a function of the immediately successively sensed changes in the capacitive coupling of a sensor structure (19, 20) to the surroundings and in the capacitive coupling of this sensor structure (19, 20) to the reference electrode.

9. Method for operating an operator control device (10) for operating an operator control device (10) which is embodied according to at least one of Claims 1 to 8, wherein the operator control device (10) has at least one operator control interface (12) with at least one operator control input field (18) for making an operator control input, and a sensor system for detecting an operator control input in the region of the operator control input field (18), wherein the sensor system has at least one first capacitive sensor device (14a) with a first, electrically conductive sensor structure (19) and one second capacitance sensor device (14b) with a second, electrically conductive sensor structure (20), wherein the sensor structures (19, 20) are arranged underneath the operator control interface (12) in the region of the operator control input field (18),
wherein, in order to detect an operator control input, the change in the capacitive coupling of the first sensor structure (19) to the surroundings and/or to a reference electrode and a change in the capacitive coupling of the second sensor structure (20) to the surroundings and/or to the reference electrode are sensed, **characterized in that**
at least the change in the capacitive coupling of the sensor structure (19) of the first capacitive sensor device (14a) and the change in the capacitive coupling of the sensor structure (20) of the second sensor device (14b) of the sensor system to the surroundings and/or to the reference electrode are sensed simultaneously or with such a short delay one after the other that safety-relevant plausibility checking of the sensed sensor signals is possible, wherein an operator control input in an operator control input field (18) is sensed with all the sensor devices (14a, 14b, 16) of the sensor system of the associated operator control input field (18) simultaneously or with a short delay one after the other.

10. Method according to Claim 9, **characterized in that**, in order to sense the change in the capacitive coupling of at least one sensor structure (19, 20) to the surroundings in a first sampling cycle (AZ1), in a first step (T1) a reference capacitance (22) and a measuring capacitance (C_{Surroundings}) formed by the sensor structure (19, 20) and the surroundings are each charged with a defined electrical potential, wherein the reference capacitance (22) is charged with a first, defined electrical potential, and the measuring capacitance (C_{Surroundings}) is charged with a second, defined electrical potential, in a further step (T2) the reference capacitance (22) and the measuring capacitance (C_{Surroundings}) formed by the sensor structure (19, 20) and the surroundings are short-circuited, and in a further step the resulting electrical potential (U_{Sensor}) which comes about between the measuring capacitance (C_{Surroundings}) and the reference capacitance (22) is sensed as a sensor signal, wherein the resulting electrical potential (U_{Sensor}) comes about as a function of the first and second electrical potentials and as a function of the magnitude of the reference capacitance (22) and as a function of the magnitude of the measuring capacitance (C_{Surroundings}).

11. Method according to Claim 10, **characterized in that** in a further sampling cycle (AZ₂), preferably in a second sampling cycle, in the first step (T₄) the reference capacitance is charged with the second electrical potential and the measuring capacitance (C_{Surroundings}) is charged with the first electrical potential, in a further step (T₅) the reference capacitance and the measuring capacitance (C_{Surroundings}) formed by the at least one sensor structure and the surroundings are short-circuited, and in a further step (T₆) the resulting electrical potential (U_{Sensor}) which comes about between the measuring capacitance (C_{Surroundings}) and the reference capacitance is sensed as a sensor signal, wherein the resulting electrical potential (U_{Sensor}) comes about as a function of the first and second potentials, as a function of the magnitude of the reference capacitance and as a function of the magnitude of the measuring capacitance (C_{Surroundings}).

12. Method according to Claim 10 or 11, wherein at least one sensor system of the operator control device (10) has a reference electrode (20) and the sensor system is embodied in such a way that an operator control input in the region of the operator control input field (18) brings about, in comparison with a reference state, a perceptible change in a capacitive coupling of at least one sensor structure (19) to the reference electrode (20),
**characterized in that**
in a further sampling cycle (AZ2), preferably in a second and/or third and/or fourth sampling cycle, in particular in addition, in a first step a defined electrical potential is applied to the reference electrode (20), and in a further step the capacitive coupling of the sensor structure (19) to the reference electrode (20) is sensed.

13. Method according to at least one of Claims 10 to 12, **characterized in that** the change in the capacitive coupling of the sensor structure (20) of a sensor device (14b) of the surroundings and/or to a reference electrode is sensed only if an operator control input has been detected previously when the change in the capacitive coupling of the sensor structure (19) of the other sensor device (14a) to the surroundings and/or to a reference electrode is sensed.

14. Method according to at least one of Claims 10 to 13, **characterized in that** if an operator control input on an operator control input field (18) is detected, a function which is assigned to the operator control input field (18) is triggered, wherein the function is preferably triggered only if a fault state of the sensor system has not been detected.

15. Method according to at least one of Claims 10 to 14, wherein the operator control device (10) has a monitoring device for detecting a fault state of at least one sensor system,
**characterized in that**
the plausibility of at least one sensor signal of at least one sensor device (14a, 14b, 16) of at least one sensor system is checked by means of the monitoring device, wherein a fault state is detected if at least one sensed and evaluated sensor signal is implausible, wherein a fault state is preferably detected if at least one sensed sensor signal of the first sensor device (14a) is implausible in comparison with at least one sensed sensor signal of the second sensor device (14b) and/or if the immediately successively sensed changes in the capacitive coupling of at least one sensor structure (19, 20) to the surroundings and in the capacitive coupling of this sensor structure (19, 20) to the reference electrode are implausible.

## Revendications

1. Dispositif d'opération (10) pour un véhicule, notamment un dispositif d'opération (10) destiné à contrôler des fonctions relatives à la sécurité, le dispositif d'opération (10) possédant
- au moins une interface d'opération (12) comprenant au moins un champ de saisie d'opération (18) servant à la saisie d'opération et
- un système capteur destiné à reconnaître une saisie d'opération dans la zone du champ de saisie d'opération (18),
le système capteur possédant au moins un premier dispositif capteur (14a) capacitif ayant une première structure de capteur (19) électriquement conductrice et un deuxième dispositif capteur (14b) capacitif ayant une deuxième structure de capteur (20) électriquement conductrice, les structures de capteur (19, 20) étant disposées au-dessous de l'interface d'opération (12) dans la zone du champ de saisie d'opération (18),
et la première structure de capteur (19) et la deuxième structure de capteur (20) étant respectivement configurées en forme de peigne et/ou en forme de méandre au moins dans une zone partielle du champ de saisie d'opération (18) et s'engrenant l'une avec l'autre, **caractérisé en ce que**
le système capteur est configuré pour détecter, par rapport à un état de référence, respectivement une modification du couplage capacitif de la première structure de capteur (10) avec l'environnement et/ou une électrode de référence et une modification du couplage capacitif de la deuxième structure de capteur (20) avec l'environnement et/ou l'électrode de référence, notamment une modification du couplage capacitif provoquée par une saisie d'opération dans la zone du champ de saisie d'opération (18), et **en ce que** le système capteur est configuré pour détecter la modification du couplage capacitif de la structure de capteur (19) du premier dispositif capteur (14a) capacitif et de la structure de capteur (20) du deuxième dispositif capteur (14b) du système capteur avec l'environnement et/ou l'électrode de référence simultanément ou rapidement l'une après l'autre de sorte qu'un contrôle de plausibilité relatif à la sécurité des signaux de capteur détectés est possible.

2. Dispositif d'opération (10) selon la revendication 1, **caractérisé en ce qu'**au moins deux premières structures de capteur (19) ou deux deuxièmes structures de capteur (20) de deux systèmes capteurs sont reliées électriquement ensemble.

3. Dispositif d'opération (10) selon la revendication 1 ou 2, **caractérisé en ce que** le système capteur est configuré de telle sorte que pour détecter la modification du couplage capacitif d'au moins une structure de capteur (19, 20) avec l'environnement, dans un premier cycle de balayage (AZ1) dans une première étape (T1), une capacité de référence (22) et une capacité de mesure (C_{Umgebung}) formée par la structure de capteur (19, 20) et l'environnement peuvent respectivement être chargées avec un potentiel électrique défini, la capacité de référence (22) pouvant être chargée avec un premier potentiel électrique défini et la capacité de mesure (C_{Umgebung}) avec un deuxième potentiel électrique défini, dans une étape supplémentaire (T2), la capacité de référence (22) et la capacité de mesure (C_{Umgebung}) formée par la structure de capteur (19, 20) et l'environnement peuvent être court-circuitées et dans une étape supplémentaire, le potentiel électrique (U_{Sensor}) résultant qui s'établit entre la capacité de mesure (C_{Umgebung}) et la capacité de référence (22) peut être détecté en tant que signal de capteur, le potentiel électrique (U_{Sensor}) résultant s'établissant en fonction du premier et du deuxième potentiel électrique ainsi qu'en fonction de la valeur de la capacité de référence (22) et de la valeur de la capacité de mesure (C_{Umgebung}).

4. Dispositif d'opération (10) selon la revendication 3, **caractérisé en ce que** le système capteur est configuré de telle sorte que dans un cycle de balayage supplémentaire (AZ2), de préférence dans un deuxième et/ou un troisième et/ou un quatrième cycle de balayage, dans la première étape (T4), la capacité de référence (22) peut être chargée avec le deuxième potentiel électrique et la capacité de mesure (C_{Umgebung}) avec le premier potentiel électrique, dans une étape supplémentaire (T5), la capacité de référence (22) et la capacité de mesure (C_{Umgebung}) formée par l'au moins une structure de capteur (19, 20) et l'environnement peuvent être court-circuitées et dans une étape supplémentaire (T6), le potentiel électrique (U_{Sensor}) résultant qui s'établit entre la capacité de mesure (C_{Umgebung}) et la capacité de référence (22) peut être détecté en tant que signal de capteur, le potentiel électrique (U_{Sensor}) résultant s'établissant en fonction du premier et du deuxième potentiel ainsi qu'en fonction de la valeur de la capacité de référence (22) et de la valeur de la capacité de mesure (C_{Umgebung}) .

5. Dispositif d'opération (10) selon au moins l'une des revendications précédentes, **caractérisé en ce qu'**au moins un système capteur possède une électrode de référence (20), l'électrode de référence (20) pouvant être alimentée avec un potentiel électrique défini et le système capteur étant configuré de telle sorte qu'une saisie d'opération dans la zone du champ de saisie d'opération (18) par rapport à un état de référence provoque une modification détectable d'un couplage capacitif entre au moins une structure de capteur (19, 20) et l'électrode de référence (20).

6. Dispositif d'opération (10) selon la revendication 5, **caractérisé en ce que** le système capteur est configuré de telle sorte que dans un cycle de balayage supplémentaire (AZ₂), de préférence dans un deuxième et/ou un troisième et/ou un quatrième cycle de balayage, notamment en plus, dans une première étape, l'électrode de référence (20) peut être alimentée avec un potentiel électrique défini et dans une étape supplémentaire, le couplage capacitif entre au moins une structure de capteur (19) et l'électrode de référence (20) peut être détecté.

7. Dispositif d'opération (10) selon au moins l'une des revendications précédentes, **caractérisé en ce que** l'au moins un système capteur est configuré pour ne détecter la modification du couplage capacitif de la structure de capteur (20) d'un dispositif capteur (14b) capacitif avec l'environnement et/ou avec une électrode de référence seulement si une saisie d'opération a précédemment été détectée lors de la détection de la modification du couplage capacitif de la structure de capteur (19) de l'autre dispositif capteur (14a) avec l'environnement et/ou avec une électrode de référence.

8. Dispositif d'opération (10) selon au moins l'une des revendications précédentes, **caractérisé en ce que** le dispositif d'opération (10) possède un dispositif de surveillance destiné à reconnaître un état de défaut d'au moins un système capteur, le dispositif de surveillance étant configuré pour contrôler la plausibilité d'au moins un signal de capteur détecté d'au moins un dispositif capteur du système capteur, notamment pour contrôler la plausibilité des signaux de capteur de tous les dispositifs capteurs du système capteur, le dispositif de surveillance reconnaissant un défaut lorsqu'au moins un signal de capteur détecté et interprété du système capteur est non plausible, le dispositif de surveillance étant de préférence configuré pour reconnaître s'il y a présence d'un état de défaut en fonction d'au moins un signal de capteur détecté du premier dispositif capteur et d'au moins un signal de capteur détecté du deuxième dispositif capteur et/ou en fonction des modifications détectées immédiatement l'une après l'autre du couplage capacitif d'une structure de capteur (19, 20) avec l'environnement et du couplage capacitif de cette structure de capteur (19, 20) avec l'électrode de référence.

9. Procédé pour faire fonctionner un dispositif d'opération (10) pour faire fonctionner un dispositif d'opération (10) qui est configuré selon au moins l'une des revendications 1 à 8, le dispositif d'opération (10) possédant au moins une interface d'opération (12) comprenant au moins un champ de saisie d'opération (18) servant à la saisie d'opération et un système capteur destiné à reconnaître une saisie d'opération dans la zone du champ de saisie d'opération (18), le système capteur possédant au moins un premier dispositif capteur (14a) capacitif ayant une première structure de capteur (19) électriquement conductrice et un deuxième dispositif capteur (14b) capacitif ayant une deuxième structure de capteur (20) électriquement conductrice, les structures de capteur (19, 20) étant disposées au-dessous de l'interface d'opération (12) dans la zone du champ de saisie d'opération (18),
en vue de reconnaître une saisie d'opération, la modification du couplage capacitif de la première structure de capteur (19) avec l'environnement et/ou une électrode de référence et une modification du couplage capacitif de la deuxième structure de capteur (20) avec l'environnement et/ou l'électrode de référence étant détectées,
**caractérisé en ce que**
au moins la modification du couplage capacitif de la structure de capteur (19) du premier dispositif capteur (14a) capacitif et de la structure de capteur (20) du deuxième dispositif capteur (14b) du système capteur avec l'environnement et/ou l'électrode de référence sont détectées simultanément ou rapidement l'une après l'autre de sorte qu'un contrôle de plausibilité relatif à la sécurité des signaux de capteur détectés est possible, une saisie d'opération dans un champ de saisie d'opération (18) étant détectée simultanément ou rapidement l'une après l'autre avec tous les dispositifs capteurs (14a, 14b, 16) du dispositif capteur du champ de saisie d'opération (18) associé.

10. Procédé selon la revendication 9, **caractérisé en ce que** pour détecter la modification du couplage capacitif d'au moins une structure de capteur (19, 20) avec l'environnement, dans un premier cycle de balayage (AZ1) dans une première étape (T1), une capacité de référence (22) et une capacité de mesure (C_{Umgebung}) formée par la structure de capteur (19, 20) et l'environnement sont respectivement chargées avec un potentiel électrique défini, la capacité de référence (22) étant chargée avec un premier potentiel électrique défini et la capacité de mesure (C_{Umgebung}) avec un deuxième potentiel électrique défini, dans une étape supplémentaire (T2), la capacité de référence (22) et la capacité de mesure (C_{Umgebung}) formée par la structure de capteur (19, 20) et l'environnement sont court-circuitées et dans une étape supplémentaire, le potentiel électrique (U_{Sensor}) résultant qui s'établit entre la capacité de mesure (C_{Umgebung}) et la capacité de référence (22) est détecté en tant que signal de capteur, le potentiel électrique (U_{Sensor}) résultant s'établissant en fonction du premier et du deuxième potentiel électrique ainsi qu'en fonction de la valeur de la capacité de référence (22) et de la valeur de la capacité de mesure (C_{Umgebung}).

11. Procédé selon la revendication 10, **caractérisé en ce que** dans un cycle de balayage supplémentaire (AZ₂), de préférence dans un deuxième cycle de balayage, dans la première étape (T4), la capacité de référence est chargée avec le deuxième potentiel électrique et la capacité de mesure (C_{Umgebung}) avec le premier potentiel électrique, dans une étape supplémentaire (T₅), la capacité de référence et la capacité de mesure (C_{Umgebung}) formée par l'au moins une structure de capteur et l'environnement sont court-circuitées et dans une étape supplémentaire (T₆), le potentiel électrique (U_{Sensor}) résultant qui s'établit entre la capacité de mesure (C_{Umgebung}) et la capacité de référence est détecté en tant que signal de capteur, le potentiel électrique (U_{Sensor}) résultant s'établissant en fonction du premier et du deuxième potentiel ainsi qu'en fonction de la valeur de la capacité de référence et de la valeur de la capacité de mesure (C_{Umgebung}).

12. Procédé selon la revendication 10 ou 11, au moins un système capteur du dispositif d'opération (10) possédant une électrode de référence (20) et le système capteur étant configuré de telle sorte qu'une saisie d'opération dans la zone du champ de saisie d'opération (18) par rapport à un état de référence provoque une modification détectable d'un couplage capacitif entre au moins une structure de capteur (19) et l'électrode de référence (20),
**caractérisé en ce que**
dans un cycle de balayage supplémentaire (AZ2), de préférence dans un deuxième et/ou un troisième et/ou un quatrième cycle de balayage, notamment en plus, dans une première étape, l'électrode de référence (20) est alimentée avec un potentiel électrique défini et dans une étape supplémentaire, le couplage capacitif de la structure de capteur (19) et l'électrode de référence (20) est détecté.

13. Procédé selon au moins l'une des revendications 10 à 12, **caractérisé en ce que** la modification du couplage capacitif de la structure de capteur (20) d'un dispositif capteur (14b) capacitif avec l'environnement et/ou avec une électrode de référence n'est détectée que si une saisie d'opération a précédemment été détectée lors de la détection de la modification du couplage capacitif de la structure de capteur (19) de l'autre dispositif capteur (14a) avec l'environnement et/ou avec une électrode de référence.

14. Procédé selon au moins l'une des revendications 10 à 13, **caractérisé en ce que** lorsqu'une saisie d'opération est détectée sur un champ de saisie d'opération (18), une fonction associée au champ de saisie d'opération (18) est déclenchée, la fonction n'étant de préférence déclenchée que si aucun état de défaut du système capteur n'a été reconnu.

15. Procédé selon au moins l'une des revendications 10 à 14, le dispositif d'opération (10) possédant un dispositif de surveillance destiné à reconnaître un état de défaut d'au moins un système capteur,
**caractérisé en ce que**
la plausibilité d'au moins un signal de capteur d'au moins un dispositif capteur (14a, 14b, 16) d'au moins un système capteur est contrôlée au moyen du dispositif de surveillance, un état de défaut étant reconnu lorsqu'au moins un signal de capteur détecté et interprété est non plausible, un état de défaut étant de préférence reconnu lorsqu'au moins un signal de capteur détecté du premier dispositif capteur (14a) est non plausible par rapport à au moins un signal de capteur détecté du deuxième dispositif capteur (14b) et/ou lorsque les modifications détectées immédiatement l'une après l'autre du couplage capacitif d'au moins une structure de capteur (19, 20) avec l'environnement et du couplage capacitif de cette structure de capteur (19, 20) avec l'électrode de référence sont non plausibles.
